# EUROPEAN PATENT APPLICATION

(11) **EP 4 776 141 A1**
(43) Date of publication of application: **15.07.2026**
(21) Application number: 24927580.1
(22) Date of filing: 21.11.2024
(51) Int. Cl.: G06F 12/02, G06F 3/06, G06F 12/0868

(54) **COMPUTATIONAL STORAGE SYSTEM AND OPERATION METHOD THEREFOR, AND ELECTRONIC SYSTEM**

(71) Applicant: Yangtze Memory Technologies Co., Ltd., Wuhan, Hubei 430074 (CN)
(72) Inventor: QIN, Dongrun, Wuhan, Hubei 430074 (CN)
(74) Representative: Lippert Stachow Patentanwälte Rechtsanwälte
(86) International application number: PCT/CN2024/133602
(87) International publication number: WO 2026/107719

(57) **Abstract**

Examples of the present disclosure provide a computational storage system, an operating method thereof, and an electronic system, the computational storage system includes a controller, a first memory coupled to the controller, and a computing processing component configured to execute a program; the first memory includes a respective storage area configured for input data / output data in a process of executing the program by the computing processing component; the controller is configured to: refresh the input data / output data in the process of executing the program into the respective storage area in batches sequentially; and a size of the input data / output data in the process of executing the program is greater than a capacity size of the respective storage area

## Description

### TECHNICAL FIELD

The present disclosure relates to, but is not limited to, a computational storage system, an operation method thereof, and an electronic system.

### BACKGROUND

Semiconductor memories may be roughly divided into two categories, depending on whether they retain stored data when powered down; these two types of semiconductor memories are: volatile memory and non-volatile memory, where volatile memory loses stored data when powered down, and non-volatile memory retains stored data when powered down.

### SUMMARY

According to a first aspect of the examples of the present disclosure, a computational storage system is provided, comprising a controller, a first memory coupled to the controller, and a computing processing component configured to execute a program; the first memory comprises a respective storage area configured for input data / output data in a process of executing the program by the computing processing component; the controller is configured to: refresh the input data / output data in the process of executing the program into the respective storage area in batches sequentially; and a size of the input data / output data in the process of executing the program is greater than a capacity size of the respective storage area.

In some implementations, the computational storage system further comprises a second memory coupled to the controller; the controller comprises a first memory unit and a second memory unit; a value in the first memory unit is to represent whether input data in a current respective storage area needs to be refreshed; a value in the second memory unit is to represent whether there is input data in the process of executing the program to be refreshed to the respective storage area; or the controller comprises a third memory unit and a fourth memory unit; a value in the third memory unit is to represent whether output data currently refreshed to the respective storage area needs to be stored to the second memory; and a value in the fourth memory unit is to represent whether there is output data in the process of executing the program to be stored to the second memory.

In some implementations, the controller is configured to: receive a first command; and in response to the first command, configure the respective storage area for the input data / output data in the process of executing the program by the computing processing component and configure a respective memory unit for the configured respective storage area.

In some implementations, the controller is configured to: receive an activation command; in response to the activation command, activate the program; receive a second command; the second command carries address information of a first batch of input data that needs to be refreshed to the respective storage area in the second memory; in response to the second command, refresh the first batch of input data into the respective storage area; based on the first batch of input data refreshed into the respective storage area being processed by the program, set a value in the first memory unit to a first value; or, based on a first batch of output data that needs to be stored into the second memory being refreshed into the respective storage area, set a value in the third memory unit to a fifth value; based on the value in the third memory unit being set to the fifth value, receive a third command; the third command carries address information that the first batch of output data that needs to be stored into the second memory needs to be stored into the second memory; and in response to the third command, store the first batch of output data that needs to be stored in the second memory into the second memory.

In some implementations, the controller is configured to: based on the value in the first memory unit being the first value, receive a fourth command; the fourth command carries address information of a Nth batch of input data that needs to be refreshed to the respective storage area in the second memory; in response to the fourth command, refresh the Nth batch of input data into the respective storage area; wherein N is an integer greater than 1; based on the Nth batch of input data having been refreshed into the respective storage area, and there being input data in the process of executing the program to be refreshed to the respective storage area, set the value in the first memory unit to a second value; or, based on the Nth batch of input data having been refreshed into the respective storage area, and all the input data in the process of executing the program having been refreshed to the respective storage area, set the value in the second memory unit to a fourth value.

In some implementations, the controller is configured to: based on the value in the third memory unit being the fifth value, receive a fifth command; the fifth command carries address information that the Nth batch of output data that needs to be stored into the second memory needs to be stored into the second memory; in response to the fifth command, store the Nth batch of output data into the second memory; wherein N is an integer greater than 1; based on the Nth batch of output data having been stored into the second memory, and there being output data in the process of executing the program to be stored into the second memory, set the value in the third memory unit to a sixth value; or, based on the Nth batch of output data having been stored into the second memory, and all the output data in the process of executing the program having been stored into the second memory, set the value in the fourth memory unit to an eighth value.

In some implementations, the controller is configured to: when an interruption occurs in the process of executing the program, based on the value in the second memory unit being the fourth value representing that all the input data in the process of executing the program has been refreshed to the respective storage area, end the program, and refresh the output data into the respective storage area.

In some implementations, the controller is configured to: receive a sixth command; the sixth command carries address information of a corresponding second memory allocated to input data that needs to be refreshed to a respective storage area in the process of executing the program, or the sixth command carries address information of a corresponding second memory allocated to output data that needs to be stored to the second memory in the process of executing the program; in response to the sixth command, refresh input data in the process of executing the program in the second memory into a respective storage area in batches sequentially, and after each time the input data in the process of executing the program in the second memory is refreshed to the respective storage area, update address information of remaining input data that needs to be refreshed to a respective storage area in the process of executing the program into the second memory; or in response to the sixth command, store output data in the process of executing the program refreshed to the respective storage area into the second memory in batches sequentially, and after each time the output data in the process of executing the program in the respective storage area is refreshed into the second memory, update address information that remaining output data that needs to be stored to the second memory in the process of executing the program needs to be stored into the second memory.

In some implementations, the first memory comprises a plurality of storage areas configured for input data in the process of executing the program; in a process of executing the program on input data in one of the plurality of storage areas by the computing processing component, the controller is configured to: perform a refresh operation on input data in a storage area that has been processed by the program of the input data stored in the plurality of storage areas; or the first memory comprises a plurality of storage areas configured for output data in the process of executing the program; and the controller is configured to: in a process of refreshing output data in the process of executing the program to one of the plurality of storage areas, store output data that has not been stored into a storage area of the second memory of the output data stored in the plurality of storage areas into the second memory.

In some implementations, the computing processing component is configured to: load the program to be executed; read input data refreshed to the respective storage area, or refresh output data obtained after the program has processed the input data into the respective storage area.

In some implementations, the computational storage system comprises a non-volatile namespace comprising the second memory, a computing namespace comprising the computing processing component, and a sub-system local memory namespace comprising the first memory.

In some implementations, the computational storage system supports simultaneous execution of a plurality of programs, the first memory comprises a corresponding storage area respectively configured for input data / output data in a process of executing each of the plurality of programs, and the controller is configured to: respectively configure a corresponding memory unit for a storage area corresponding to each of the plurality of programs, and configure a corresponding memory unit for each of the plurality of programs.

According to a second aspect of the examples of the present disclosure, an electronic system is provided, comprising a host and a computational storage system coupled to the host, wherein the computational storage system comprises a controller, a first memory coupled to the controller, and a computing processing component configured to execute a program; wherein the host is configured to: send a first command; the controller is configured to: receive the first command; in response to the first command, configure a respective storage area for input data / output data in a process of executing the program by the computing processing component; and refresh the input data / output data in the process of executing the program into the respective storage area in batches sequentially; and a size of the input data / output data in the process of executing the program is greater than a capacity size of the respective storage area.

In some implementations, the computational storage system further comprises a second memory coupled to the controller; the controller comprises a first memory unit and a second memory unit; a value in the first memory unit is to represent whether input data in a current respective storage area needs to be refreshed; a value in the second memory unit is to represent whether there is input data in the process of executing the program to be refreshed to the respective storage area; or the controller comprises a third memory unit and a fourth memory unit; a value in the third memory unit is to represent whether output data currently refreshed to the respective storage area needs to be stored to the second memory; and a value in the fourth memory unit is to represent whether there is output data in the process of executing the program to be stored to the second memory.

In some implementations, the host is configured to: send an activation command; send a second command; the second command carries address information of a first batch of input data that needs to be refreshed to a respective storage area in the second memory; the controller is configured to: receive the activation command; in response to the activation command, activate the program; receive the second command; in response to the second command, refresh the first batch of input data into the respective storage area; based on the first batch of input data refreshed into the respective storage area being processed by the program, set a value in the first memory unit to a first value; or the host is configured to: send a third command; the third command carries address information that the first batch of output data that needs to be stored into the second memory needs to be stored into the second memory; the controller is configured to: based on a first batch of output data that needs to be stored into the second memory being refreshed into the respective storage area, set a value in the third memory unit to a fifth value; based on the value in the third memory unit being set to the fifth value, receive the third command; and in response to the third command, store the first batch of output data that needs to be stored into the second memory in the second memory.

In some implementations, the host is configured to: send a command to obtain the value in the first memory unit; based on the value in the first memory unit being the first value, send a fourth command; the fourth command carries address information of a Nth batch of input data that needs to be refreshed to the respective storage area in the second memory; wherein N is an integer greater than 1; send a seventh command; the seventh command carries information that the Nth batch of input data that needs to be refreshed to a respective storage area has been refreshed to the respective storage area, and information about whether there is input data in the process of executing the program to be refreshed to the respective storage area; the controller is configured to: receive a command to obtain the value in the first memory unit; in response to the command to obtain the value in the first memory unit, send the value in the first memory unit to the host; receive the fourth command, and in response to the fourth command, refresh the Nth batch of input data into the respective storage area; receive the seventh command; in response to the information carried in the seventh command being that there is input data in the process of executing the program to be refreshed to the respective storage area, set the value in the first memory unit to a second value; or, in response to the information carried in the seventh command being that the input data in the process of executing the program has been refreshed to the respective storage area, set the value in the second memory unit to a fourth value.

In some implementations, the host is configured to: send a command to obtain a value in the third memory unit; based on the value in the third memory unit being the fifth value, send a fifth command; the fifth command carries address information that the Nth batch of output data that needs to be stored into the second memory needs to be stored into the second memory; wherein N is an integer greater than 1; send an eighth command; the eighth command carries information about the Nth batch of output data has been stored into the second memory and whether there is output data in the process of executing the program to be stored in the second memory; the controller is configured to: receive a command to obtain a value in the third memory unit; in response to the command to obtain the value in the third memory unit, send the value in the third memory unit to the host; receive the fifth command; in response to the fifth command, store the Nth batch of output data into the second memory; receive the eighth command; in response to the information carried in the eighth command being that there is output data in the process of executing the program to be stored into the second memory, set a value in the third memory unit to a sixth value; or, in response to the information carried in the eighth command being that all the output data in the process of executing the program has been stored into the second memory, set a value in the fourth memory unit to an eighth value.

In some implementations, the host is configured to: send a sixth command ; the sixth command carries address information of a corresponding second memory allocated to input data that needs to be refreshed to a respective storage area in the process of executing the program; or, the sixth command carries address information of a corresponding second memory allocated to output data that needs to be stored to the second memory in the process of executing the program; the controller is configured to: receive the sixth command; in response to the sixth command, refresh input data in the process of executing the program in the second memory into a respective storage area in batches sequentially, and after each time the input data in the process of executing the program in the second memory is refreshed to the respective storage area, update address information of remaining input data that needs to be refreshed to a respective storage area in the process of executing the program in the second memory; or in response to the sixth command, store output data in the process of executing the program refreshed to the respective storage area into the second memory in batches sequentially, and after each time the output data in the process of executing the program in the respective storage area is refreshed into the second memory, update address information that remaining output data that needs to be stored to the second memory in the process of executing the program needs to be stored into the second memory.

In some implementations, the host is configured to: send a command to configure a plurality of storage areas for input data / output data in the process of executing the program; the controller is configured to: configure the plurality of storage areas for input data in the process of executing the program; in a process of executing the program on input data in one of the plurality of storage areas by the computing processing component, perform a refresh operation on input data in a storage area that has been processed by the program of the input data stored in the plurality of storage areas; or the controller is configured to: configure the plurality of storage areas for output data in the process of executing the program; and in a process of refreshing output data in the process of executing the program to one of the plurality of storage areas, store output data that has not been stored into a storage area of the second memory of the output data stored in the plurality of storage areas into the second memory.

According to a third aspect of the examples of the present disclosure, an operation method for a computational storage system is provided, comprising: configuring a respective storage area for input data / output data in a process of executing a program by a computing processing component; refreshing the input data / output data in the process of executing the program into the respective storage area in batches sequentially; and a size of the input data / output data in the process of executing the program is greater than a capacity size of the respective storage area.

In some implementations, a corresponding first memory unit is configured for a respective storage area configured for input data in the process of executing the program, and a respective second memory unit is configured for the program; a value in the first memory unit is to represent whether input data in a current respective storage area needs to be refreshed; a value in the second memory unit is to represent whether there is input data in the process of executing the program to be refreshed to the respective storage area; or a corresponding third memory unit is configured for a respective storage area configured for output data in the process of executing the program, and a respective fourth memory unit is configured for the program; a value in the third memory unit is to represent whether output data currently refreshed to the respective storage area needs to be stored to the second memory; and a value in the fourth memory unit is to represent whether there is output data in the process of executing the program to be stored to the second memory.

In some implementations, the operation method further comprises: receiving a first command; and in response to the first command, configuring the respective storage area for the input data / output data in the process of executing the program by the computing processing component and configuring a respective memory unit for the configured respective storage area.

In some implementations, the operation method further comprises: receiving an activation command; in response to the activation command, activating the program; receiving a second command; the second command carries address information of a first batch of input data that needs to be refreshed to the respective storage area in the second memory; in response to the second command, refreshing the first batch of input data into the respective storage area; based on the first batch of input data refreshed into the respective storage area being processed by the program, setting a value in the first memory unit to a first value; or, based on a first batch of output data that needs to be stored into the second memory being refreshed into the respective storage area, setting a value in the third memory unit to a fifth value; based on the value in the third memory unit being set to the fifth value, receiving a third command; the third command carries address information that the first batch of output data that needs to be stored into the second memory needs to be stored in the second memory; and in response to the third command, storing the first batch of output data that needs to be stored in the second memory into the second memory.

In some implementations, the operation method further comprises: based on the value in the first memory unit being the first value, receiving a fourth command; the fourth command carries address information of a Nth batch of input data that needs to be refreshed to the respective storage area in the second memory; in response to the fourth command, refreshing the Nth batch of input data into the respective storage area; wherein N is an integer greater than 1; based on the Nth batch of input data having been refreshed into the respective storage area, and there being input data in the process of executing the program to be refreshed to the respective storage area, setting the value in the first memory unit to a second value; or, based on the Nth batch of input data having been refreshed into the respective storage area, and all the input data in the process of executing the program having been refreshed to the respective storage area, setting the value in the second memory unit to a fourth value.

In some implementations, the operation method further comprises: based on the value in the third memory unit being the fifth value, receiving a fifth command; the fifth command carries address information that the Nth batch of output data that needs to be stored into the second memory needs to be stored in the second memory; in response to the fifth command, storing the Nth batch of output data into the second memory; wherein N is an integer greater than 1; based on the Nth batch of output data having been stored into the second memory, and there being output data in the process of executing the program to be stored into the second memory, setting the value in the third memory unit to a sixth value; or, based on the Nth batch of output data having been stored into the second memory, and all the output data in the process of executing the program having been stored into the second memory, setting the value in the fourth memory unit to an eighth value.

In some implementations, the operation method further comprises: when an interruption occurs in the process of executing the program, based on the value in the second memory unit being the fourth value representing that all the input data in the process of executing the program has been refreshed to the respective storage area, ending the program, and refreshing the output data into the respective storage area.

In some implementations, the operation method further comprises: receiving a sixth command; the sixth command carries address information of a corresponding second memory allocated to input data that needs to be refreshed to a respective storage area in the process of executing the program, or the sixth command carries address information of a corresponding second memory allocated to output data that needs to be stored to the second memory in the process of executing the program; in response to the sixth command, refreshing input data in the process of executing the program in the second memory into a respective storage area in batches sequentially, and after each time the input data in the process of executing the program in the second memory is refreshed to the respective storage area, updating address information of remaining input data that needs to be refreshed to a respective storage area in the process of executing the program in the second memory; or in response to the sixth command, storing output data in the process of executing the program refreshed to the respective storage area into the second memory in batches sequentially, and after each time the output data in the process of executing the program in the respective storage area is refreshed into the second memory, updating address information that remaining output data that needs to be stored to the second memory in the process of executing the program needs to be stored into the second memory.

In some implementations, the first memory comprises a plurality of storage areas configured for input data in the process of executing the program; in a process of executing the program on input data in one of the plurality of storage areas by the computing processing component, the operation method further comprises: performing a refresh operation on input data in a storage area that has been processed by the program of the input data stored in the plurality of storage areas; or the first memory comprises a plurality of storage areas configured for output data in the process of executing the program; and the operation method further comprises: in a process of refreshing output data in the process of executing the program to one of the plurality of storage areas, storing output data that has not been stored into a storage area of the second memory of the output data stored in the plurality of storage areas into the second memory.

### BRIEF DESCRIPTION OF DRAWINGS

FIG. 1 is a first schematic structural diagram of an electronic system according to an example of the present disclosure;
FIG. 2 is a first schematic structural diagram of a computational storage system according to an example of the present disclosure;
FIG. 3 is a schematic diagram of an example of loading a program in an electronic system according to an example of the present disclosure;
FIG. 4 is a schematic diagram of an example of program execution in an electronic system according to an example of the present disclosure;
FIG. 5 is a schematic diagram of a memory range and a memory range set according to an example of the present disclosure;
FIG. 6a is a second schematic structural diagram of a computational storage system according to an example of the present disclosure;
FIG. 6b is a third schematic structural diagram of a computational storage system according to an example of the present disclosure;
FIG. 7 is a first schematic diagram of interaction between a host and a computational storage system according to an example of the present disclosure;
FIG. 8 is a second schematic diagram of interaction between a host and a computational storage system according to an example of the present disclosure;
FIG. 9 is a third schematic diagram of interaction between a host and a computational storage system according to an example of the present disclosure;
FIG. 10 is a fourth schematic structural diagram of a computational storage system according to an example of the present disclosure;
FIG. 11 is a fourth schematic diagram of interaction between a host and a computational storage system according to an example of the present disclosure;
FIG. 12 is a second schematic structural diagram of an electronic system according to an example of the present disclosure;
FIG. 13 is a schematic flowchart of an operation method for a computational storage system according to an example of the present disclosure.

### DETAILED DESCRIPTION

Exemplary implementations disclosed in the present disclosure will be described in more detail below with reference to the accompanying drawings. Although exemplary implementations of the present disclosure are shown in the accompanying drawings, it is to be understood that the present disclosure may be implemented in various forms and should not be limited to the implementations set forth herein. Rather, these implementations are provided so that the present disclosure can be more thoroughly understood and the scope disclosed in the present disclosure can be fully conveyed to those skilled in the art.

In the following description, numerous details are given in order to provide a more thorough understanding of the present disclosure. However, it will be apparent to one skilled in the art that the present disclosure may be practiced without one or more of these details. In other examples, in order to avoid confusion with the present disclosure, some technical features known in the art are not described; that is, not all features of the actual examples are described here, and well-known functions and structures are not described in detail.

In the drawings, like reference numerals refer to like elements throughout.

It should be understood that spatial relation terms such as "beneath," "below," "lower," "under", "above," "upper," etc., may be used herein for ease of description to describe the relationship between one element or feature and other elements or features shown in the figures. It should be appreciated that in addition to the orientations shown in the figures, the spatial relation term intent to also include different orientations of the devices in use and operation. For example, if the devices in the figures are flipped, then described as "below" or "under" or "beneath" other elements or features will be oriented "on" other elements or features. Thus, the exemplary terms "below" and "under" may include both upper and lower orientations. The devices may be additionally oriented (rotated 90 degrees or other orientations) and the spatial description terminology used herein is interpreted accordingly.

A term used herein is for the purpose of describing a specific example only and is not to be considered as limitation of the present disclosure. As used herein, the singular forms "a", "an" and "said/the" are intended to include the plural forms as well, unless the context clearly dictates otherwise. It should also be understood that the terms "consists of" and/or "comprising", when used in this description, identify the presence of stated features, integers, steps, operations, elements and/or parts, but do not exclude the presence or addition of one or more other features, integers, steps, operations, elements, parts and/or groups. As used herein, the term "and/or" includes any and all combinations of the associated listed items.

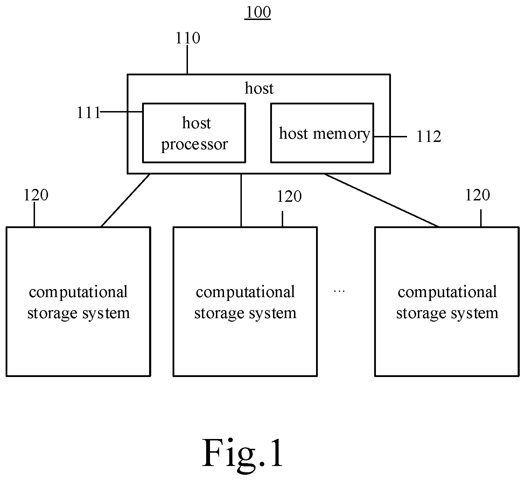

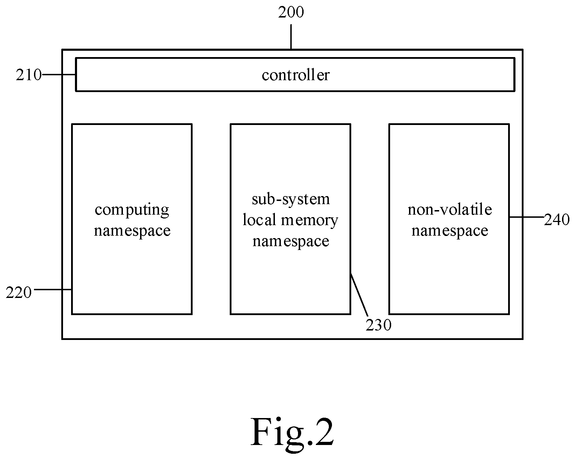

FIG. 1 is a schematic structural diagram of an electronic system according to an example of the present disclosure. FIG. 2 is a schematic structural diagram of a computational storage system according to an example of the present disclosure.

Referring to FIG. 1, an electronic system 100 may comprise a host 110 and at least one computational storage system 120. The host 110 may comprise a host processor 111 and a host memory 112. The host processor 111 may control the overall operation of the host 110. The host processor 111 may be implemented as at least one of various processing units (comprising, for example, a central processing unit (CPU), an application processor (AP), a graphics processing unit (GPU), a neural processor unit (NPU), a field programmable gate array (FPGA), and / or a microprocessor. In some examples, the host processor 111 may be implemented as a system on chip (SoC). The host memory 112 may store data, instructions, and programs needed for the operation of the host processor 111. The host memory 112 may be a volatile memory. Volatile memory comprises, but is not limited to, random access memory (RAM), dynamic random access memory (DRAM), static random access memory (SRAM), synchronous dynamic random access memory (SDRAM), double data rate synchronous dynamic random access memory (DDR SDRAM).

The computational storage system 120 may be a semiconductor device that provides computing services and data storage services. The computational storage system 120 may be used as both a data storage in the electronic system 100 and a computing device for executing programs. In some examples, for example, the computational storage system 120 may be implemented as part of a data center or artificial intelligence training data device.

In some examples, host 110 and computational storage system 120 may be physically connected through an interface and comply with corresponding PCIe / NVMe protocol communications. For example, the host 110 and the computational storage system 120 may be connected through a network link, for example, based on an NVMe-OF protocol connection. For example, the host 110 and the computational storage system 120 may also be connected through a compute express link (CXL) interface, and the host 110 may control the operation of the computational storage system 120 via a compute express link (CXL) interface. The computational storage system 120 is configured to comply with the computational storage protocol of NVMe. The CXL interface may comprise CXL.io, CXL.cache, and CXL.mem as sub-protocols. The host 110 may load a predetermined program to the computational storage system 120 for processing. The host 110 may load various types of programs, such as applications, kernels, and / or computations, to the computational storage system 120. The program may comprise, for example, an encryption program, a compression program, an image recognition program, a filter program, and / or an artificial intelligence program.

Referring to FIG. 2, in some examples, the computational storage system 200 may comprise a controller 210, one or more sub-system local memory namespaces (SLM NS) 230, one or more non-volatile memory namespaces (NVM NS) 240, and one or more computing namespaces (CNS) 220. The computational storage system 200 may correspond to one of the plurality of computational storage systems 120 shown in FIG. 1. The sub-system local memory namespace 230 may be a namespace implemented by volatile memory that is closer to the computing processing components of the computing namespace 220 relative to the namespace implemented by the non-volatile memory. Non-volatile namespace 240 may be a namespace implemented by a non-volatile memory.

In some examples, the computational storage system 200 may use a non-volatile memory express protocol as a memory protocol, and the controller 210 may be an NVMe controller. The controller 210 may store input data / output data in a process of executing a program into the sub-system local memory namespace 230 and / or read input data / output data stored in the sub-system local memory namespace 230 in response to an input / output (I / O) request from the host.

In some examples, the controller 210 may execute various operations for controlling the non-volatile namespace 240 or other non-volatile memory. For example, various operations may comprise address mapping operations, wear leveling operations, and / or garbage collection operations. The address mapping operation may be a translation operation between a logical address managed by the host or controller and a physical address of the non-volatile namespace 240. Wear leveling may be an operation of equalizing the use frequency or number of multiple memory blocks included in the non-volatile namespace 240. The garbage collection operation may be an operation of copying valid data from the source block of the non-volatile namespace 240 to the target block and then erasing the source block to ensure the available blocks or free blocks in the non-volatile namespace 240.

In some examples, the computing namespace 220 may be used as an abstraction that represents one or more computing engines for executing programs. The computing engine resources may be composed of one or more of a CPU, an FPGA, a GPU, an ASIC, or the like. For example, the computing namespace may comprise a CPU core and an FPGA. The computing engine resource may be part of the controller 210, or may be part independent of the controller 210. The computing engine may execute a program pre-loaded from the host. In some examples, the program may be stored in a program slot. Program slot may be formed in the computing engine, or may be allocated in separate memory. In some examples, a program slot in which a program is stored may be within the computing namespace 220, or may form a computing namespace 220, which is an entity capable of executing programs. The computing namespace 220 may be, for example, an entity in an NVMe sub-system. The computing namespace 220 can access the sub-system local memory namespace 230. In some examples, the computational storage system 200 may comprise one or more computing namespaces 220. If the computational storage system 200 comprises multiple computing namespaces 220, the host may load plurality of programs to multiple computing namespaces 220 (e.g., in a one-to-one relationship), respectively. Thus, each loaded program may be managed in a respective computing namespace 220, and the present disclosure is not limited thereto.

In some examples, the controller 210 may copy the data stored in the non-volatile namespace 240 to the sub-system local memory namespace 230, and / or may copy the data stored in the sub-system local memory namespace 230 to the non-volatile namespace 240, that is, the controller 210 may control the data migration of the non-volatile namespace 240 and the local memory namespace 230 according to the need for program processing of the computing namespace 220.

The sub-system local memory namespace 230 may store input data to be used by programs to be executed, or may store results (output data) obtained from executing programs. In some examples, the sub-system local memory namespace 230 may also be accessed by the controller 210. The sub-system local memory namespace 230 may be implemented, for example, as DRAM.

In some examples, the controller 210 may also comprise a first control portion (not shown) that controls the sub-system local memory namespace 230, such as a cache controller. In some examples, the first control portion may be disposed as a chip separate from the controller 210. In some other examples, the first control portion may be disposed as an internal component of the controller 210.

Non-volatile namespace 240 may store input date / output data in a process of executing a program. Non-volatile namespace 240 may comprise, for example, flash memory such as NAND flash memory. In another example, the non-volatile namespace 240 may comprise, for example, phase change memory, resistive memory, magnetoresistive memory, ferroelectric memory, or polymer memory. In some examples, the computational storage system 200 may also comprise a second control portion, such as a flash controller, that controls or is configured to control the non-volatile namespace 240, which may be included in the controller 210.

In the examples of the present disclosure, the computing processing component in the computational storage system comprises a computing engine resource that is abstracted into one or more computing namespaces for use by a user. A RAM inside the computing processing component in the computational storage system, a common RAM inside the computational storage system, and a RAM inside the controller may all be abstracted into a sub-system local namespace to be provided to the user for use. For a user, these computing namespaces and the sub-system local memory namespaces are in a parallel relationship, and in some implementations, the user may be informed that a certain sub-system local memory namespace is used by a certain computing namespace (because of a physical dependency) according to an internal specific physical implementation.

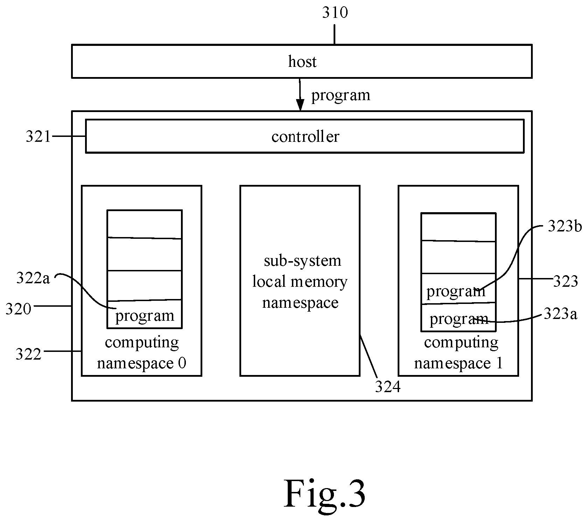

FIG. 3 is a schematic diagram of an example of loading a program in an electronic system according to an example of the present disclosure.

Referring to FIG. 3, host 310 may load a program to computational storage system 320. In FIG. 3, the computational storage system 320 is shown to comprise a computing namespace 322 and a computing namespace 323 (e.g., computing namespaces 0 and 1), but the number of computing namespaces is not limited thereto.

In some examples, computing namespace 322 and computing namespace 323 may support device-defined programs and / or downloadable programs. The device-defined program may be, for example, a fixed program provided by a manufacturer, and the downloadable program may be a program loaded into the computing namespace 322 and the computing namespace 323 by the host 310. For example, the device-defined program 323a may be disposed in the computing namespace 323.

In some examples, the controller 321 of the computational storage system 320 may receive the programs 322a and 323b transmitted from the host 310 and store in the computational storage system 320. In response to program execution commands from the host 310, the computing engine of the computing namespace may execute programs 322a, 323a, and / or 323b in the computing namespace 322 and computing namespace 323 using input data stored in the sub-system local memory namespace 324, which may be respective input parameters required for program execution, and / or the like.

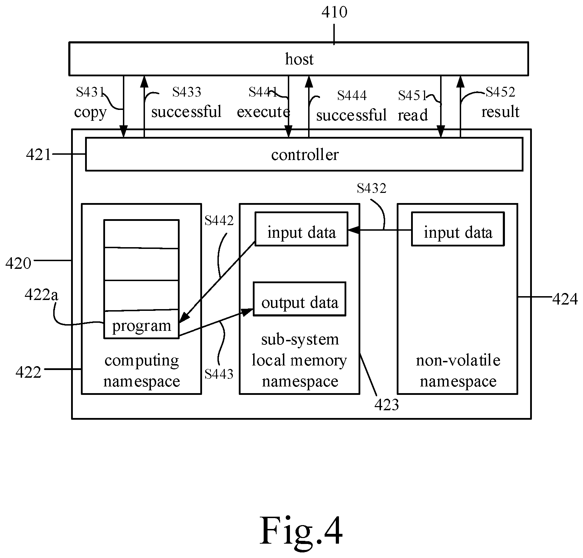

FIG. 4 is a schematic diagram of an example of program execution in an electronic system according to an example of the present disclosure. In FIG. 4, assume that program 422a is loaded into computing namespace 422 of computational storage system 420.

Referring to FIG. 4, in operation S431, the host 410 may send a data copy command to the controller 421 of the computational storage system 420. In operation S432, in response to the data copy command, input data stored in non-volatile memory namespace 424 (e.g., non-volatile memory device) may be copied to sub-system local memory namespace 423. In some examples, the controller 421 may control the non-volatile namespace 424 and the sub-system local memory namespace 423 in response to the data copy command to transfer input data from the non-volatile namespace 424 to the sub-system local memory namespace 423.

It should be noted that FIG. 4 is only an example, and is not intended to limit the transmission path of the input data and the output data in the examples of the present disclosure. In some examples, the host 410 may directly write the input data into the sub-system local memory namespace 423, and the output data obtained after the input data is processed by the program is stored into the sub-system local memory namespace 423, and the host 410 may directly obtain the output data from the sub-system local memory namespace 423, that is, the non-volatile namespace 424 may not be involved in the storage of input data and the storage of output data. In some other examples, the non-volatile namespace 424 may also be involved in the storage of input data and the storage of output data, the host 410 may write the input data into the non-volatile namespace 424, the non-volatile namespace 424 copies the input data to the sub-system local memory namespace 423, the output data obtained after the input data is processed by the program is stored in the sub-system local memory namespace 423, the output data in the sub-system local memory namespace 423 is copied into the non-volatile namespace 424, and the host may obtain the output data from the non-volatile namespace 424. In still other examples, the non-volatile namespace 424 may only be involved in one of the storage of input data and the storage of output data, for example, the host 410 may directly write the input data into the sub-system local memory namespace 423, the output data obtained after the input data is processed by the program is stored into the sub-system local memory namespace 423, the output data in the sub-system local memory namespace 423 is copied into the non-volatile namespace 424, and the host 410 may obtain the output data from the non-volatile namespace 424; or the host 410 may write the input data into the non-volatile namespace 424, the input data in the non-volatile namespace 424 is copied to the sub-system local memory namespace 423, the output data obtained after the input data is processed by the program is stored in the sub-system local memory namespace 423, and the host 410 may directly obtain the output data from the sub-system local memory namespace 423.

After copying data from NVM namespace 424 to the sub-system local memory namespace 423, in operation S433, controller 421 may send a read success message to host 410.

To execute the program, in operation S441, the host 410 may send program execution commands to the computational storage system 420 to execute the program 422a in the computing namespace 422. In some examples, the controller 421 may receive program execution commands from the host 410. In operation S442, in response to the program execution command, the computing engine in the computing namespace 422 may execute the program 422a in the computing namespace 422 using the input data stored in the sub-system local memory namespace 423. In operation S443, the computing namespace may store the execution result (output data) of the program 422a into the sub-system local memory namespace 423. After the execution of the program 422a in the computing namespace 422 is completed, in operation S444, the controller 421 may send a message indicating successful execution of the program to the host 410.

In some examples, in operation S451, the host 410 may send a read command indicating to read output data from the sub-system local memory namespace 423 to the computational storage system 420. In operation S452, the controller 421 may read the output data (e.g., the execution result of the program 422a) from the sub-system local memory namespace 423 and transmit the data to the host 410.

In some examples, after the execution of the program 422a is completed, the output data may be flushed down from the sub-system local memory namespace 423 to the non-volatile namespace 424.

The electronic system may execute programs on the computational storage system 420 by performing the operations described above. Further, if requested by the host 410, the electronic system may provide execution results of the program from the computational storage system 420 to the host 410.

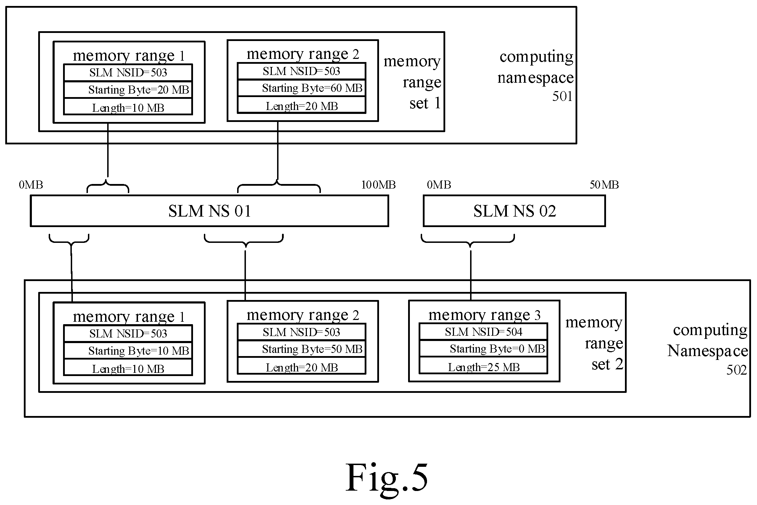

In some examples, the controller 421 configures a respective storage area in the memory of the sub-system local memory namespace 423 for storing the input data / output data in the process of executing a program in response to a command of the host. In some examples, the controller may configure a respective storage area by creating a memory range, where one memory range (MR) may define one corresponding storage area, the memory range may be represented by a sub-system local memory namespaces identity (SLM NS ID), a starting byte of the storage area in the local memory namespace, and a length, and each memory range may specify a range in which the sub-system local memory namespace may be accessed. A set of memory ranges constitutes a memory range set (MRS). The memory range set may be stored in a computing namespace, each execution of the program being limited to accessing a range other than the range specified by the memory range set in the program name. As shown in FIG. 5, the memory range 1 and the memory range 2 in the computing namespace 501 constitute a memory range set 1, and the memory range 1, the memory range 2, and the memory range 3 in the computing namespace 502 constitute a memory range set 2, each memory range comprises information related to a sub-system local memory namespaces identity (SLM NS ID), a starting byte of the storage area in the local memory namespace, and a length, and one area in the sub-system local memory namespace corresponding to the memory range may be obtained by the information included in the memory range. It should be noted that an example in which the memory range set is stored in the computing namespace is used as an example for description in FIG. 5, but the examples of the present disclosure are not limited thereto, and the memory range set may also be stored in other memories having a storage function of the computational storage system.

All input date / output data in a process of executing a program is stored in the sub-system local memory namespace. With the rise of applications such as big data and artificial intelligence, in some scenarios (for example, AI training), a size of input data / output data (for example, an input parameter of a large model of some AI training programs may reach a data size on the order of GB) is much larger than a capacity size of a storage area configured for input data / output data, thereby affecting normal execution of a program.

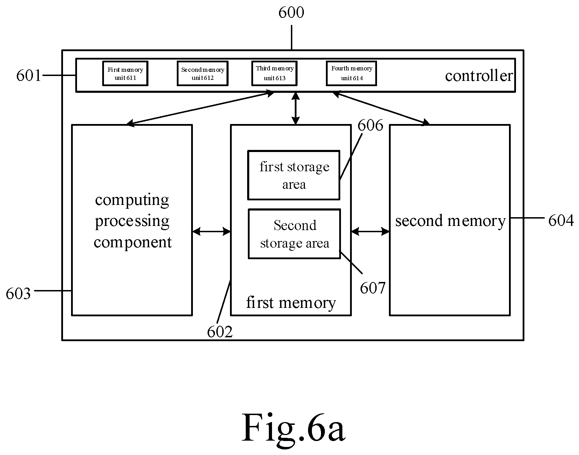

The present disclosure provides a computational storage system, as shown in FIG. 6a, the computational storage system 600 comprises a controller 601, a first memory 602 coupled to the controller 601, and a computing processing component 603 configured to execute a program; the first memory 602 comprises a respective storage area configured for input data / output data in the process of executing the program by the computing processing component 603; the controller 601 is configured to: refresh the input data / output data in the process of executing the program into the respective storage area in batches sequentially; and a size of the input data / output data in the process of executing the program is greater than a capacity size of the respective storage area.

In the examples of the present disclosure, the input data / output data in a process of executing a program is refreshed to the respective storage area in batches sequentially, and when the size of the input data / output data in a process of executing a program is greater than the capacity size of the respective storage area, normal execution of the program can also be ensured, that is, it is not necessary to limit the size of the input data / output data in the process of executing a program to be smaller than the capacity size of the respective storage area in the example of the present disclosure, so that the requirement for the size of the input data / output data in the process of executing a program can be relaxed, and the application range of the computational storage system is improved.

In some specific examples, the first memory 602 is a volatile memory, comprising but not limited to a random access memory (RAM), a dynamic random access memory (DRAM), a static random access memory (SRAM), a synchronous dynamic random access memory (SDRAM), a double data rate synchronous dynamic random access memory (DDR SDRAM). The computing processing component 603 has a computing function, comprising but not limited to a computing engine, and the computing engine resource may be composed of one or more of a CPU, an FPGA, a GPU, an ASIC, or the like. The computing processing component 603 may be a part of the controller 601 or a part independent of the controller 601.

In some specific examples, as shown in FIG. 6a, the first memory 602 comprises a first storage area 606 configured for input data in a process of executing a program by the computing processing component 603, and a second storage area 607 configured for output data in a process of executing a program by the computing processing component 603. The capacity size of the first storage area 606 is smaller than the size of the input data in the process of executing a program, and the capacity size of the second storage area 607 is smaller than the size of the output data in the process of executing a program. The controller 601 is configured to: refresh the input data in the process of executing a program into the first storage area 606 in batches sequentially, and / or refresh the output data in the process of executing a program into the second storage area 607 in batches sequentially.

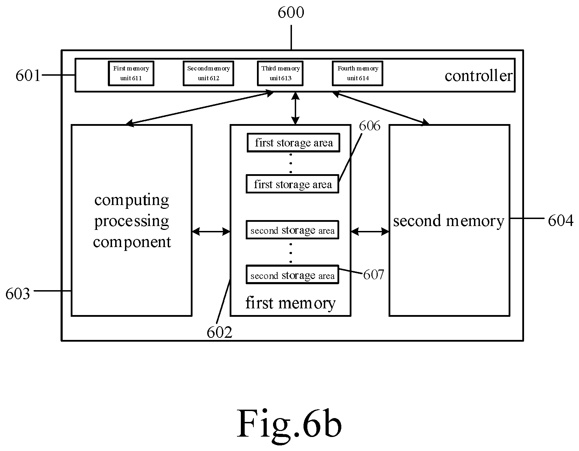

In some specific examples, as shown in FIG. 6b, the first memory 602 comprises a plurality of first storage areas 606 configured for input data in a process of executing a program by the computing processing component 603, and the capacity size of the plurality of first storage areas 606 is smaller than the size of input data in a process of executing a program. The first memory 602 comprises a second storage area 607 configured for output data in the process of executing the program by the computing processing component 603, and the capacity size of the plurality of second storage areas 607 is smaller than the size of the output data in the process of executing a program.

The solution provided by the example of the present disclosure is applicable to input data in the process of executing the program and output data in the process of executing the program. The following first takes the input data in the process of executing a program as an example for description.

In some examples, as shown in FIG. 6a and FIG. 6b, the controller 601 comprises a first memory unit 611 and a second memory unit 612; a value in the first memory unit 611 is configured to represent whether input data in a current respective storage area needs to be refreshed; and a value in the second memory unit 612 is configured to represent whether there is input data in the process of executing the program to be refreshed to the respective storage area.

The first memory unit 611 and the second memory unit 612 herein may be registers, for example, they may be implemented by different means of the same register, or implemented by different registers; the first memory unit 611 and the second memory unit 612 may also be a segment of a memory in the controller 601. The first memory unit 611 may be configured to store a value representing whether the input data in the current first storage area 606 needs to be refreshed, for example, the value in the first memory unit 611 is a first value, representing that the input data in the current first storage area 606 needs to be refreshed, and the value in the first memory unit 611 is a second value, representing that the input data in the current first storage area 606 does not need to be refreshed. The second memory unit 612 may be configured to store a value representing whether there is input data in the process of executing the program to be refreshed to the first storage area 606; for example, the value in the second memory unit 612 is a third value, representing that there is input data in the process of executing a program to be refreshed to the first storage area 606, and the value in the second memory unit 612 is a fourth value, representing that all the input data in the process of executing a program has been refreshed to the first storage area 606. For example, the first value here may be one of "1" and "0", and the second value may be the other of "1" and "0". For example, the third value here may be one of "1" and "0", and the fourth value may be the other of "1" and "0".

In the examples of the present disclosure, the controller 601 provides the first memory unit 611 associated with the first storage area 606, and the value in the first memory unit 611 reflects whether the input data in the current first storage area 606 has been processed by the program, that is, whether the input data in the first storage area 606 needs to be updated. When the input data in the current first storage area 606 has been processed by the program, the input data in the first storage area 606 needs to be refreshed; when the input data in the current first storage area 606 has not been processed by the program, the input data in the first storage area 606 does not need to be refreshed. Further, in the examples of the present disclosure, the controller 601 provides the second memory unit 612 associated with the program, and the value in the second memory unit 612 reflects whether all the input data in the current process of executing the program has been refreshed into the first storage area 606.

In some examples, the controller 601 is configured to: receive a first command; and in response to the first command, configure the respective storage area for the input data in the process of executing the program by the computing processing component 603 and configure a respective memory unit for the configured respective storage area.

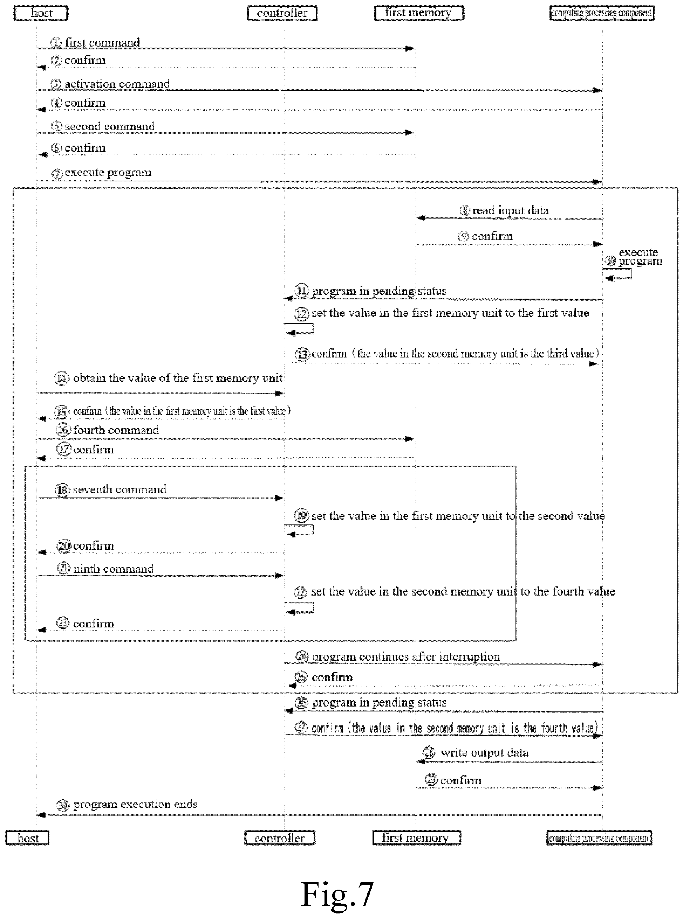

As shown by ① in FIG. 7, the controller 601 receives a first command sent by the host 605, where the first command may be a command to create a memory range set, and after receiving the first command, the controller 601 allocates a storage area in the first memory for input data / output data in the process of executing the program, where the first command carries a memory range identity document (MRID) and a symbol indicating that the first memory unit 611 needs to be allocated to the first storage area 606 corresponding to the memory range in the memory range set and that the second memory unit 612 needs to be allocated to the program to be executed; as shown by ② in FIG. 7, when the controller finishes allocating the storage area in the first memory to the input data / output data in the process of executing the program, the controller 601 may send, to the host 605, a message indicating that creation of the memory range set is successfully confirmed, where the message confirming that the memory range set is successfully created may carry the address of the first memory unit 611 and the address of the second memory unit 612.

In some specific examples, the controller 601 is configured to initialize a value of the first memory unit 611 to a second value, and initialize a value of the second memory unit 612 to a third value.

In some examples, as shown in FIG. 6a, the computational storage system 600 further comprises a second memory 604 coupled to the controller 601.

In some specific examples, the second memory 604 is a non-volatile memory, comprising but not limited to flash memory such as NAND flash memory, phase change memory, resistive memory, magnetoresistive memory, ferroelectric memory, or polymer memory. The second memory 604 may be configured to store input data / output data in the process of executing the program.

In some examples, the controller 601 is configured to: receive an activation command; in response to the activation command, activate the program; receive a second command; the second command carries address information of a first batch of input data that needs to be refreshed to the respective storage area in the second memory 604; in response to the second command, refresh the first batch of input data into the respective storage area; and based on the first batch of input data refreshed into the respective storage area being processed by the program, set a value in the first memory unit 611 to a first value.

In some examples, the computing processing component 603 is configured to: load the program to be executed; and read the input data refreshed to the respective storage area.

In some specific examples, the program to be executed may also not be loaded by the computing processing component 603, such as for a fixed program provided by the manufacturer.

As shown by ③ in FIG. 7, the controller 601 receives the activation command sent by the host 605, and the controller 601 may activate the program to be executed in the computing processing component 603 in response to the activation command; as shown by ④ in FIG. 7, when the program to be executed in the computing processing component 603 is activated successfully, the controller 601 may send, to the host 605, a message indicating that the activation of program is successful confirmed; as shown by ⑤ in FIG. 7, the controller 601 receives the second command sent by the host 605, where the second command indicates that the first batch of input data that needs to be refreshed from the second memory 604 to the first storage area 606 is refreshed to the first storage area 606, and the second command carries the address information of the input data that needs to be refreshed to the first storage area 606 in the second memory 604; as shown by ⑥ in FIG. 7, when the first batch of input data that needs to be refreshed from the second memory 604 to the first storage area 606 is refreshed to the first storage area 606 of the first memory, the controller 601 may send, to the host 605, a message indicating that the first batch of input data that needs to be refreshed from the second memory 604 to the first storage area 606 being refreshed to the first storage area 606 is successfully confirmed; as shown by ⑦ in FIG. 7, the controller 601 receives the command to execute the program sent by the host 605, where the command to execute the program may carry the address information of the first memory unit 611 and the address information of the second memory unit 612, and the command to execute the program instructs the computing processing component to execute the program; as shown by ⑧ in FIG. 7, the computing processing component 603 reads the input data stored in the first storage area 606 of the current first memory 602; as shown by ⑨ in FIG. 7, the first memory 602 sends, to the computing processing component 603, a message indicating that the computing processing component 603 reading the input data stored in the first storage area 606 of the current first memory 602 is successfully confirmed; as shown by ⑩ in FIG. 7, the computing processing component 603 executes the program; as shown by ⑪ in FIG. 7, when the computing processing component 603 processes the input data (the first batch of input data that is refreshed into the first storage area 606) stored in the first storage area 606 of the current first memory 602, the computing processing component 603 feeds back, to the controller 601, that the program is in pending status; as shown by ⑫ in FIG. 7, the controller 601 sets the value in the first memory unit 611 to the first value; as shown by ⑬ in FIG. 7, the controller 601 determines that the value in the second memory unit 612 is the third value according to the fact that the program in the computing processing component has not finished executing, that is, there is input data to be refreshed into the first storage area.

In some examples, the controller 601 is configured to: based on the value in the first memory unit 611 being the first value, receive a fourth command; the fourth command carries address information of a Nth batch of input data that needs to be refreshed to the respective storage area in the second memory 604; in response to the fourth command, refresh the Nth batch of input data into the respective storage area; wherein N is an integer greater than 1; based on the Nth batch of input data having been refreshed into the respective storage area, and there being input data in the process of executing the program to be refreshed to the respective storage area, set the value in the first memory unit 611 to a second value; or, based on the Nth batch of input data having been refreshed into the respective storage area, and all the input data in the process of executing the program having been refreshed to the respective storage area, set the value in the second memory unit 612 to a fourth value.

As shown by ⑭ in FIG. 7, the controller 601 receives the command to obtain the value in the first memory unit 611 sent by the host 605, and the host 605 sends the command to obtain the value in the first memory unit 611 to the controller 601 periodically; as shown by ⑮ in FIG. 7, the controller 601 notifies the host 605 of the value of the first memory unit 611 in response to the command to obtain the value in the first memory unit 611 sent by the host 605; as shown by ⑯ in FIG. 7, when the value in the first memory unit 611 is the first value, the controller 601 receives the fourth command sent by the host 605, where the fourth command indicates that the Nth batch of input data that needs to be refreshed from the second memory 604 to the first storage area 606 of the first memory is refreshed to the first storage area 606, and the fourth command carries the address information of the Nth batch of input data that needs to be refreshed to the first storage area 606 in the second memory 604; as shown by ⑰ in FIG. 7, the controller 601 may send, to the host 605, the message indicating that the Nth batch of input data that needs to be refreshed from the second memory 604 to the first storage area 606 of the first memory is refreshed to the first storage area 606 successfully; as shown by ⑱ in FIG. 7, when the Nth batch of input data has been refreshed into the first storage area 606, the controller 601 receives the seventh command sent by the host 605, where the seventh command carries information indicating that there is also input data in the process of executing the program to be refreshed to the first storage area 606; as shown by ⑲ in FIG. 7, the controller 601 sets the value in the first memory unit 611 to the second value in response to the seventh command; as shown by ⑳ in FIG. 7, the controller 601 sends, to the host 605, a message indicating that updating the value in the first memory unit 611 is successfully confirmed; or, as shown by 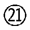 in FIG. 7, when the Nth batch of input data has been refreshed into the first storage area 606, the controller 601 receives the ninth command sent by the host 605, where the ninth command carries the information indicating that all the input data in the process of executing the program has been refreshed into the first storage area 606; as shown by 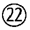 in FIG. 7, the controller 601 sets the value in the second memory unit 612 to the fourth value in response to the ninth command; as shown by 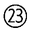 in FIG. 7, the controller 601 sends, to the host 605, a message indicating that updating the value in the second memory unit 612 is successfully confirmed.

In some examples, the controller 601 is configured to: when an interruption occurs in the process of executing the program, based on the value in the second memory unit 612 being disposed to the fourth value representing that all the input data in the process of executing the program has been refreshed to the respective storage area, end the program, and refresh the output data into the respective storage area.

In some examples, the computing processing component 603 is configured to: refresh output data obtained after the program has processed the input data into the respective storage area.

In some examples, the output data obtained after the program processes the input data may be automatically refreshed into the second storage area 607.

As shown by 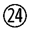 in FIG. 7, when an interrupt occurs in the process of executing the program, the controller 601 sends a command to continue after the program is interrupted to the computing processing component 603; as shown by 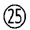 in FIG. 7, the computing processing component 603 sends a message indicating that the command to continues after the program is interrupted is successfully confirmed to the controller 601; as shown by 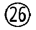 in FIG. 7, when the program is in the pending status, the computing processing component 603 notifies the controller 601 of the message indicating that the program is in the pending status; as shown by 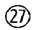 in FIG. 7, when the value in the second memory unit 612 is the fourth value, the controller 601 notifies the computing processing component 603 of the message indicating that the value in the second memory unit 612 is the fourth value; as shown by 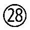 in FIG. 7, the computing processing component 603 writes the output data in the process of executing the program into the first memory 602, and in other specific examples, the output data may also be refreshed into the first memory 602 in batches sequentially in the process of executing the program; as shown by 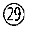 in FIG. 7, the first memory 602 sends, to the computing processing component 603, a message indicating that the output data in the process of executing the program written into the first memory 602 is successfully confirmed; as shown by 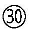 in FIG. 7, the controller notifies the host 605 of the message indicating that the program execution ends based on the execution of the program in the computing processing component being finished.

In some examples, the controller 601 is configured to: receive a sixth command; the sixth command carries address information of a corresponding second memory allocated to input data that needs to be refreshed to a respective storage area in the process of executing the program;

in response to the sixth command, refresh input data in the process of executing the program in the second memory 604 into a respective storage area in batches sequentially, and after each time the input data in the process of executing the program in the second memory 604 is refreshed to the respective storage area, update address information of remaining input data that needs to be refreshed to a respective storage area in the process of executing the program in the second memory 604.

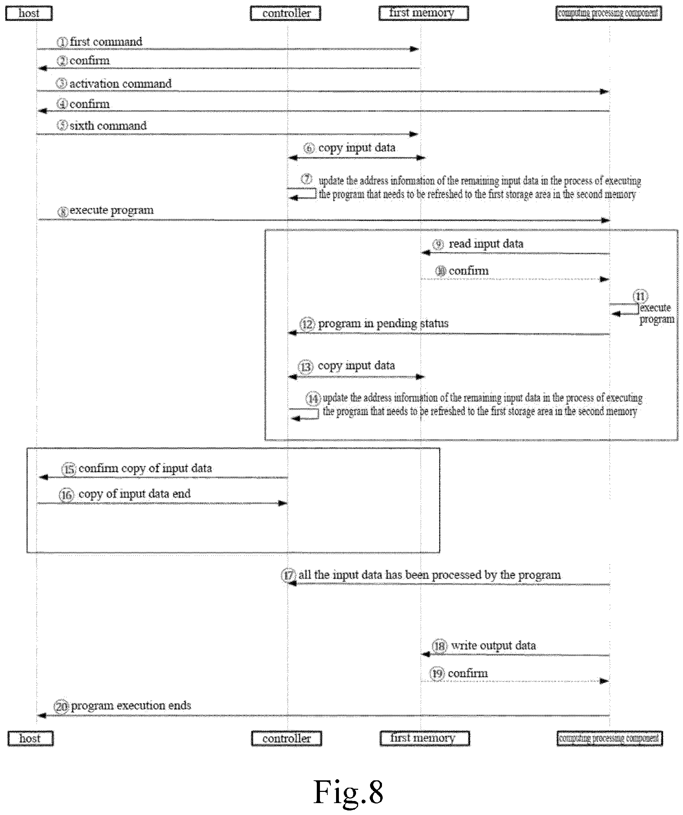

As shown by ① in FIG. 8, the first command may not carry the symbol indicating that the first memory unit needs to be allocated to the first storage area 606 corresponding to the memory range in the memory range set, and the first command may not carry the symbol indicating that the second memory unit needs to be allocated to the program to be executed, and the other aspects are similar to ① to ④ in FIG. 7 and will not repeated herein again. As shown by ⑤ in FIG. 8, the controller 601 receives a sixth command sent by the host 605, where the sixth command is configured to indicate that the input data that needs to be refreshed from the second memory 604 to the first storage area 606 of the first memory is refreshed to the first storage area 606, and the sixth command carries address information of the corresponding second memory 604 allocated to the input data that needs to be refreshed to the respective storage area in the process of executing the program, that is, the sixth command carries address information of all the input data in the process of executing the program to be stored in the second memory 604, and the address information comprises a starting address of all the input data in the process of executing the program that needs to be stored in the first storage area 606 in the second memory 604 and a data length, and indicates that the operation that the input data that needs to be refreshed from the second memory 604 to the first storage area 606 is refreshed to the first storage area 606 is only performed after the program is in the pending status; as shown by ⑥ in FIG. 8, the controller 601 refreshes the first batch of input data in the process of executing the program into the first storage area 606 in the first memory 602 in response to the sixth command; as shown by ⑦ in FIG. 8, after the first batch of input data in the process of executing the program is refreshed to the first storage area 606 in the first memory 602, the controller 601 updates the address information of the remaining input data in the process of executing the program that needs to be refreshed to the first storage area 606 in the second memory 604.

As shown by ⑧ in FIG. 8, the controller 601 receives a command to execute a program sent by the host 605, and the computing processing component 603 is informed of the command by the controller 601; as shown by ⑨ in FIG. 8, the computing processing component 603 reads the first batch of input data stored in the first storage area 606 of the first memory 602; as shown by ⑩ in FIG. 8, the first memory 602 informs the computing processing component 603 of a message indicating that the reading of the first batch of input data stored in the first storage area 606 of the first memory 602 by computing processing component 603 is successfully confirmed; as shown by ⑪ in FIG. 8, the computing processing component 603 executes a program to process the read first batch of input data stored in the first storage area 606; as shown by ⑫ in FIG. 8, when the program finishes processing the read first batch of input data stored in the first storage area 606, the computing processing component 603 informs the controller 601 that the program is in the pending status; as shown by ⑬ in FIG. 8, after learning that the program is in the pending status, the controller 601 sends a command to copy the input data to the first memory 602, where the command to copy the input data can indicate that the Nth batch of input data in the process of executing the program is refreshed into the first storage area 606 in the first memory 602; as shown by ⑭ in FIG. 8, after the Nth batch of input data in the process of executing the program is refreshed to the first storage area 606 in the first memory 602, the controller 601 updates the address information of the remaining input data in the process of executing the program that needs to be refreshed to the first storage area 606 in the second memory 604; the operations of ⑨ to ⑭ in FIG. 8 can be performed repeatedly until the last batch of input data in the process of executing the program is refreshed into the first storage area 606 in the first memory 602; as shown by ⑮ in FIG. 8, after the last batch of input data in the process of executing the program is refreshed into the first storage area 606 in the first memory 602, the controller 601 can send a message indicating that the copy of input data is successfully confirmed to the host 605.

As shown by ⑯ in FIG. 8, the host 605 sends a command to end copying the input data, or the host 605 may also send a new command to copy the input data; as shown by ⑰ in FIG. 8, when the computing processing component 603 finishes processing the last batch of input data that is refreshed to the first storage area 606, the computing processing component 603 notifies the controller 601 of the message that all the input data has been processed by the program; as shown by ⑱ in FIG. 8, the computing processing component 603 writes the result (output data) obtained after the program is executed into the first memory 602; as shown by ⑲ in FIG. 8, after writing the result obtained after the program is executed by the computing processing component 603 into the first memory 602, the first memory 602 informs the computing processing component 603 of the message indicating that the result obtained after the program is executed by the computing processing component 603 is written into the first memory 602 successfully.

In the example shown in FIG. 8, the host 605 issues, in advance, the address information of the corresponding second memory 604 allocated to all the input data in the process of executing the program that needs to be refreshed to the first storage area 606, and instructs the controller 601 to refresh the input data in the second memory 604 into the first storage area 606 when detecting that the program is in the pending status, and the controller 601 may be notified that whether the program is in the pending status by the computing processing component 603, and when the controller 601 is notified that the program is in the pending status, the controller 601 may immediately issue a command to refresh the input data in the first storage area 606, so that the latency after the program is in the pending status may be reduced. In the above example, the controller 601 may autonomously determine the time node for refreshing the data and reduce the influence of the data refresh on the normal input / output of the host.

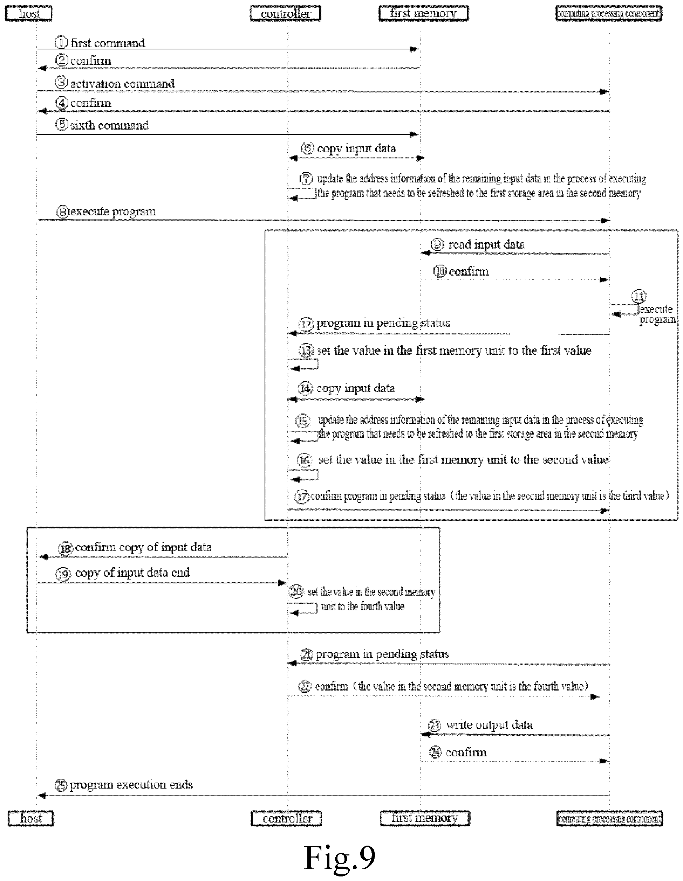

The example shown in FIG. 9 is similar to the example shown in FIG. 8, based on the example shown in FIG. 8, it may be further added that the controller 601 provides the first memory unit 611 associated with the first storage area 606, and whether the input data in the current first storage area 606 has been processed by the program can be reflected by the value in the first memory unit 611, and the value in the first memory unit 611 indicates whether the input data in the first storage area 606 needs to be updated. The controller 601 is configured to initialize the value of the first memory unit 611 to a second value, and initialize the value of the second memory unit 612 to a third value. As shown by ① in FIG. 9, the first command carries the symbol indicating that the first memory unit needs to be allocated to the first storage area 606 corresponding to the memory range in the memory range set, and that the second memory unit 612 needs to be allocated to the program to be executed; as shown by ⑬ in FIG. 9, after the controller 601 learns that the program in the computing processing component is in the pending status, the controller 601 may set the value in the first memory unit 611 to the first value; as shown by ⑭ in FIG. 9, the controller 601 may send a command to copy the input data to the first memory 602 based on the value in the first memory unit 611 being the first value, so as to refresh the input data in the first storage area 606; as shown by ⑯ in FIG. 9, after the input data in the first storage area 606 is refreshed, the controller 601 sets the value in the first memory unit to the second value; as shown by ⑳ in FIG. 9, after the host 605 sends the command to end copying the input data, the controller 601 sets the value in the second memory unit 612 to the fourth value; as shown by 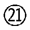 in FIG. 9, after the computing processing component 603 processes the last batch of input data in the first storage areas 606, the computing processing component 603 notifies the controller 601 of the message that the program is in the pending status; as shown by 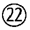 in FIG. 9, the controller 601 sends a message indicating that the value in the second memory unit 612 being the fourth value is confirmed to the computing processing component 603; as shown by 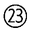 in FIG. 9, the computing processing component 603 writes the result (output data) obtained after the program is executed into the first memory 602 based on the value in the second memory unit 612 being the fourth value.

In some examples, the first memory 602 comprises a plurality of storage areas configured for input data in the process of executing the program; in a process of executing the program on input data in one of the plurality of storage areas by the computing processing component 603, the controller 601 is configured to: perform a refresh operation on input data in a storage area that has been processed by the program of the input data stored in the plurality of storage areas.

In the examples of the present disclosure, the first storage area group may be configured for input data in the process of executing the program, the first storage area group comprises a plurality of first storage areas 606, and when the computing processing component 603 executes a program on the input data in one of the plurality of first storage areas 606, the input data of the first storage areas 606 other than the first storage area 606 in which stored input data that has been processed by the program may be refreshed, and in the examples of the present disclosure, on the basis of configuring the plurality of first storage areas 606, the ping-pong policy is used to refresh the input data in another first storage area 606 in the process of executing the program, so that the time for the program to be in the pending status may be further reduced, thereby improving program execution efficiency. In some examples, the input data of the plurality of first storage areas 606 of the corresponding program may not be performed serially.

In some specific examples, the controller is configured to configure a corresponding first memory unit 611 for each first storage area in the first storage area group.

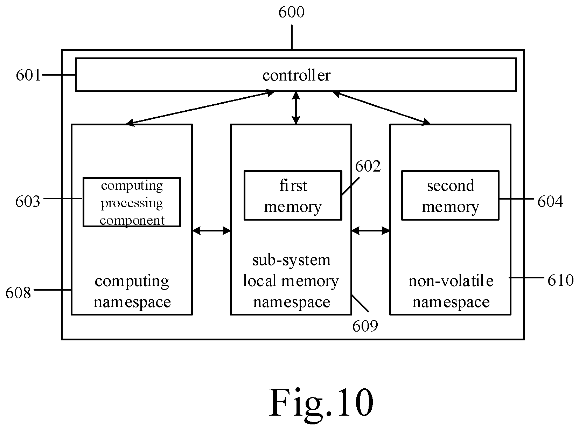

In some examples, as shown in FIG. 10, the computational storage system 600 comprises a non-volatile namespace 610, a computing namespace 608, and a sub-system local memory namespace 609; the non-volatile namespace 610 comprises a second memory 604, the computing namespace 608 comprises a computing processing component 603, and the sub-system local memory namespace 609 comprises the first memory 602.

In some examples, the computational storage system 600 supports simultaneous execution of a plurality of programs, the first memory 602 comprises a corresponding storage area respectively configured for input data in a process of executing each of the plurality of programs, and the controller 601 is configured to: configure a corresponding memory unit for a storage area corresponding to each of the plurality of programs, and configure a corresponding memory unit for each of the plurality of programs.

In the solution provided in the examples of the present disclosure, when the plurality of programs are executed simultaneously, one or more corresponding first storage areas 606 may be configured for input data in the process of executing each program, and the first storage area 606 corresponding to each program may be respectively configured with a corresponding first memory unit 611 (for example, a register), and each program may be configured with a respective second memory unit 612, so that when each of the plurality of programs is executed, the input data in the process of executing the program can be refreshed into the respective first storage area 606 in batches sequentially.

The solution provided in the examples of the present disclosure is further applicable to output data in the process of executing the program. The batch sequential refresh of the output data in the process of executing the program is similar to the batch sequential refresh of the output data in the process of executing the program, and the following uses the output data in the process of executing the program as an example for description.

In some examples, as shown in FIG. 6a and FIG. 6b, the computational storage system 600 further comprises a second memory 604 coupled to the controller 601; the controller 601 comprises a third memory unit 613 and a fourth memory unit 614; a value in the third memory unit 613 is configured to represent whether the output data currently refreshed into the respective storage area needs to be stored to the second memory 604; and a value in the fourth memory unit 614 is configured to represent whether there is output data in the process of executing the program to be stored in the second memory 604.

The third memory unit 613 and the fourth memory unit 614 herein may be a register, or may be a segment of a memory in the controller 601. The third memory unit 613 may be configured to store a value representing whether the output data currently refreshed to the second storage area 607 needs to be stored to the second memory 604, for example, the value in the third memory unit 613 is the fifth value, representing that the output data currently refreshed to the second storage area 607 has not been stored to the second memory 604, and therefore needs to be stored to the second memory 604, and the value in the third memory unit 613 is the sixth value, representing that the output data currently refreshed to the second storage area 607 has been stored to the second memory 604, and therefore the output data currently refreshed to the second storage area 607 does not need to be stored to the second memory 604. The fourth memory unit 614 may be configured to store a value representing whether there is output data in the process of executing a program to be stored to the second memory 604; for example, the value in the fourth memory unit 614 is the seventh value, representing that there is output data in the process of executing the program to be stored to the second memory 604; for example, the value in the fourth memory unit 614 is the eighth value, representing that all the output data in the process of executing the program to be stored to the second memory 604 has been stored to the second memory 604. For example, the fifth value may be one of "1" and "0", and the sixth value may be the other of "1" and "0". For example, the seventh value may be one of "1" and "0", and the eighth value may be the other of "1" and "0".

In the examples of the present disclosure, the controller 601 provides the third memory unit 613 associated with the second storage area 607, and the value in the third memory unit 613 reflects whether the output data obtained after the input data in the current first storage area 606 is processed by the program is refreshed into the second storage area 607, that is, whether the output data in the second storage area 607 needs to be stored in the second memory 604. When the output data obtained after the input data in the current first storage area 606 is processed by the program is refreshed into the second storage area 607, the output data in the second storage area 607 needs to be stored in the second memory 604; when the program is still in the process of processing the input data in the current first storage area 606, or when the output data obtained after the input data in the current first storage area 606 is processed by the program has not been refreshed into the second storage area 607, the output data in the current second storage area 607 has been stored in the second memory 604, so the output data in the current second storage area 607 does not need to be stored in the second memory 604. Further, in the examples of the present disclosure, the controller 601 provides the fourth memory unit 614 associated with the program, and the value in the fourth memory unit 614 reflects whether all the output data in the current process of executing the program have been stored in the second memory 604.

In some examples, the controller 601 is configured to: receive a first command; and in response to the first command, configure the respective storage area for the output data in the process of executing the program by the computing processing component 603 and configure a respective memory unit for the configured respective storage area.

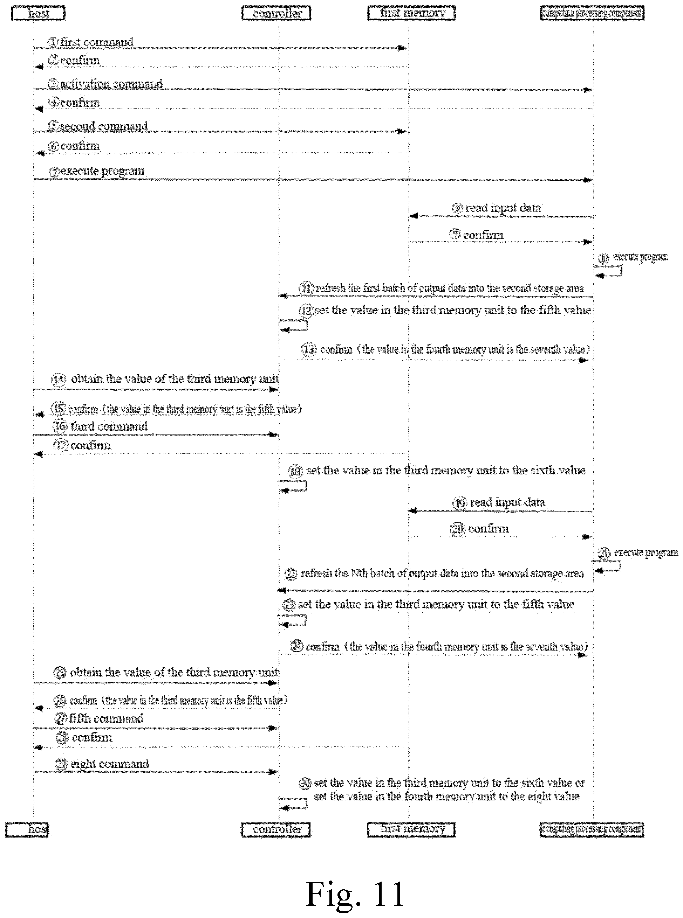

As shown by ① in FIG. 11, the controller 601 receives a first command sent by the host 605, where the first command may be a command to create a memory range set, and the first command carries a memory range identity document (MRID) and a symbol indicating that the third memory unit 613 needs to be allocated to the second storage area 607 corresponding to the memory range in the memory range set and that the fourth memory unit 614 needs to be allocated to the program to be executed; as shown by ② in FIG. 11, the controller 601 may send a message indicating that the creation of memory range set is successfully confirmed to the host 605, where the message indicating that the creation of memory range set is successfully confirmed may carry the address of the third memory unit 613 and the address of the fourth memory unit 614.

In some specific examples, the controller 601 is configured to: initialize the value of the third memory unit 613 to the sixth value, and initialize the value of the fourth memory unit 614 to the seventh value.

In some examples, the computing processing component 603 is configured to: load the program to be executed; and read the input data refreshed to the first storage area 606.

In some examples, the computing processing component 603 is configured to: load a program to be executed; and refresh the output data obtained after the input data is processed by the program into the respective storage area.

How to refresh the output data in the process of executing the program into the second storage area 607 in batches sequentially will be further described below with reference to FIG. 11, and how to store the output data refreshed to the second storage area 607 in batches sequentially to the second memory 604 sequentially will be further described.

In some examples, the controller 601 is configured to: receive an activation command; activate the program in response to the activation command; receive a second command; the second command carries address information of the first batch of input data that needs to be refreshed to the respective storage area in the second memory 604; in response to the second command, refresh the first batch of input data into the respective storage area; and based on the first batch of output data that needs to be stored to the second memory 604 being refreshed into the respective storage area, set the value in the third memory unit 613 to the fifth value.

As shown by ③ in FIG. 11, the controller 601 receives the activation command sent by the host 605, and the controller 601 may activate the program to be executed in the computing processing component 603 in response to the activation command; as shown by ⑤ in FIG. 11, the controller 601 receives the second command sent by the host 605, where the second command indicates that the first batch of input data that needs to be refreshed from the second memory 604 to the first storage area 606 is refreshed to the first storage area 606, and the second command carries the address information of the first batch of input data that needs to be refreshed to the first storage area 606 in the second memory 604; as shown by ⑥ in FIG. 11, after the first batch of input data that needs to be refreshed from the second memory 604 to the first storage area 606 of the first memory 602 is refreshed to the first storage area 606, the controller 601 may send, to the host 605, a message indicating that the first batch of input data that needs to be refreshed from the second memory 604 to the first storage area 606 being refreshed to the first storage area 606 is successfully confirmed; as shown by ⑦ in FIG. 11, the controller 601 receives a command to execute the program sent by the host 605, and the command to execute the program instructs to execute the program in the computing processing component; as shown by ⑧ in FIG. 11, the computing processing component 603 reads the input data currently stored in the first storage area 606 of the first memory 602; as shown by ⑩ in FIG. 11, the computing processing component 603 executes the program to generate the first batch of output data, and automatically refreshes the generated first batch of output data into the second storage area 607; as shown by ⑪ in FIG. 11, the computing processing component 603 feeds back a message indicating that refreshing the generated first batch of output data into the second storage area 607 is successful to the controller 601; as shown by ⑫ in FIG. 11, the controller 601 sets the value in the third memory unit 613 to the fifth value; as shown by ⑬ in FIG. 11, the controller 601 confirms that the value in the fourth memory unit 614 is the seventh value.

In some examples, the controller 601 is configured to: receive a third command based on the value in the third memory unit 613 being set to a fifth value; the third command carries address information that the first batch of output data that needs to be stored into the second memory 604 needs to be stored in the second memory 604; and in response to the third command, store the first batch of output data that needs to be stored in the second memory 604 in the second memory 604.

As shown by ⑭ in FIG. 11, the controller 601 receives the command to obtain the value in the third memory unit 613 sent by the host 605, and the host 605 sends the command to obtain the value in the third memory unit 613 to the controller 601 periodically; as shown by ⑮ in FIG. 11, the controller 601 notifies the host 605 of the value of the third memory unit 613 in response to the command to obtain the value in the third memory unit 613 sent by the host 605; as shown by ⑯ in FIG. 11, when the value in the third memory unit 613 is the fifth value, the controller 601 receives the third command sent by the host 605, where the third command indicates that the first batch of output data that is refreshed to the second storage area 607 is stored in the second memory 604, and the third command carries the address information that the first batch of output data that needs to be stored in the second memory 604 needs to be stored in the second memory 604; the controller 601 stores the first batch of output data that needs to be stored in the second memory 604 in the second memory 604 in response to the third command; as shown by ⑰ in FIG. 11, the controller 601 may send the message indicating that the first batch of output data that needs to be stored in the second memory 604 being stored in the second memory 604 is successfully confirmed to the host 605. As shown by ⑱ in FIG. 11, after the controller 601 stores the first batch of output data that needs to be stored in the second memory 604 in the second memory 604, the controller 601 may set the value in the third memory unit 613 to the sixth value.

In some examples, the controller 601 is configured to: based on the value in the third memory unit 613 being the fifth value, receive a fifth command; the fifth command carries address information that the Nth batch of output data that needs to be stored into the second memory 604 needs to be stored in the second memory 604; in response to the fifth command, store the Nth batch of output data into the second memory 604; wherein N is an integer greater than 1; based on the Nth batch of output data having been stored into the second memory 604, and there being output data in the process of executing the program to be stored into the second memory 604, set the value in the third memory unit 613 to a sixth value; or, based on the Nth batch of output data having been stored into the second memory 604, and all the output data in the process of executing the program having been stored into the second memory 604, set the value in the fourth memory unit 614 to an eighth value.

As shown by ⑲ to 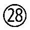 in FIG. 11, the computing processing component 603 processes the Nth batch of input data that is refreshed into the first storage area 606 to obtain the Nth batch of output data, and automatically refreshes the Nth batch of output data into the second storage area 607; the computing processing component 603 feeds back a message indicating that the generated Nth batch of output data is successfully refreshed into the second storage area 607 to the controller 601; the controller 601 sets the value in the third memory unit 613 to the fifth value; the controller 601 confirms that the value in the fourth memory unit 614 is the seventh value; the controller 601 receives the fifth command sent by the host 605 based on the value in the third memory unit 613 being the fifth value, and the fifth command carries the address information that the Nth batch of output data that needs to be stored in the second memory 604 needs to be stored in the second memory 604; and the controller 601 stores the Nth batch of output data into the second memory 604 in response to the fifth command.

In some specific examples, as shown by 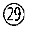 to 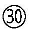 in FIG. 11, the controller 601 sets the value in the third memory unit 613 to the sixth value based on the Nth batch of output data having been stored into the second memory 604, and there being output data in the process of executing the program to be stored into the second memory 604; or the controller 601 sets the value in the fourth memory unit 614 to the eighth value based on the Nth batch of output data having been stored into the second memory 604, and all the output data in the process of executing the program having been stored into the second memory 604.

In some examples, the controller 601 is configured to: receive a sixth command; the sixth command carries address information of a corresponding second memory 604 allocated to output data in the process of executing the program that needs to be stored to the second memory 604; in response to the sixth command, store output data in the process of executing the program refreshed to the respective storage area into the second memory 604 in batches sequentially, and after each time the output data in the process of executing the program in the respective storage area is refreshed into the second memory 604, update address information that remaining output data that needs to be stored to the second memory 604 in the process of executing the program needs to be stored into the second memory 604.

The controller 601 receives a sixth command sent by the host 605, where the sixth command is configured to instruct to store the output data that needs to be stored into the second memory 604 into the second memory 604, where the sixth command carries address information of the corresponding second memory 604 allocated to the output data that needs to be stored to the second memory 604 in the process of executing the program, that is, the sixth command carries address information of the corresponding second memory 604 allocated to all the output data that needs to be stored to the second memory 604 in the process of executing the program, and the address information comprises a starting address of all output data in the process of executing the program needed to be stored in the second storage area 607 that needs to be stored in the second memory 604 and a data length, and indicates that the operation that the output data that needs to be stored to the second memory 604 is stored to the second memory 604 is only performed after the computing processing component 603 processes the input data to obtain the corresponding output data and refreshes the output data into the second storage area 607, and after each time the output data in the second storage area 607 is stored into the second memory 604, updates address information that remaining output data that needs to be stored to the second memory 604 in the process of executing the program needs to be stored into the second memory 604. After the first batch of input data in the process of executing the program is refreshed into the first storage area 606 in the first memory 602.

In the above example, the host 605 issues, in advance, the address information of the corresponding second memory 604 allocated to the output data that needs to be stored to the first memory 602 in the process of executing the program, and instructs the controller 601 to store the output data that is currently refreshed to the second storage area 607 to the second memory 604 when detecting that the corresponding output data obtained by processing the input data in the current first storage area 606 by the program has been refreshed to the second storage area 607, the controller 601 may be notified by the computing processing component 603 that whether the corresponding output data obtained by processing the input data in the current first storage area 606 by the program has been refreshed to the second storage area 607, and when the controller 601 is notified that the corresponding output data obtained by processing the input data in the current first storage area 606 by the program has been refreshed to the second storage area 607, the controller 601 may immediately issue a command to store the output data currently refreshed to the second storage area 607 to the second memory 604, so that the latency after the corresponding output data obtained by processing the input data in the current first storage area 606 by the program has been refreshed to the second storage area 607 may be reduced.

In some examples, the first memory 602 comprises a plurality of storage areas configured for output data in the process of executing the program; and the controller 601 is configured to: in a process of refreshing output data in the process of executing the program to one of the plurality of storage areas, store output data that has not been stored into a storage area of the second memory 604 in the output data stored in the plurality of storage areas into the second memory 604.

In the examples of the present disclosure, the second storage area group may be configured for output data in the process of executing the program, the second storage area group comprises a plurality of second storage areas 607, and in the process of refreshing, by the computing processing component 603, the output data in the process of executing the program to one of the plurality of second storage areas 607, output data of the output data stored in the second storage areas 607 other than the second storage area 607 that is not stored to the second memory 604 may be stored to the second memory 604, and in the example of the present disclosure, on the basis of configuring the plurality of second storage areas 607, the output data in another second storage area 607 is stored in the second memory 604 by using the ping-pong policy when the second storage area 607 is refreshed, so that the program execution efficiency may be improved.

In some examples, the controller is configured to: configure a corresponding third memory unit 613 for each second storage area in the second storage area group.

In some examples, the computational storage system 600 supports simultaneous execution of a plurality of programs, the first memory 602 comprises a corresponding storage area respectively configured for output data in a process of executing each of the plurality of programs, and the controller 601 is configured to: configure a corresponding memory unit for a storage area corresponding to each of the plurality of programs, and configure a corresponding memory unit for each of the plurality of programs.

In the solution provided by the examples of the present disclosure, when a plurality of programs are executed simultaneously, a corresponding second storage area 607 is configured for output data in the process of executing each program, and the second storage area 607 corresponding to each program is respectively configured with a corresponding third memory unit 613, and each program is configured with a corresponding fourth memory unit 614, so that when each of the plurality of programs is executed, the output data in the process of executing the program can be refreshed into the corresponding second storage area 607 in batches sequentially, and further, when each of the plurality of programs is executed, the output data in the process of executing the program can be stored into the second memory 604 in batches sequentially from the second storage area 607.

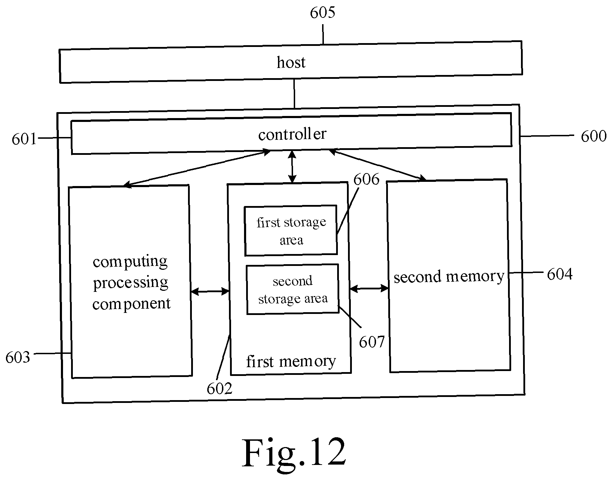

Based on the above computational storage system, an example of the present disclosure further provides an electronic system, as shown in FIG. 12, the electronic system comprises a host 605 and a computational storage system 600 coupled to the host 605, the computational storage system 600 comprises a controller 601, a first memory 602 coupled to the controller 601, and a computing processing component 603 configured to execute a program; wherein the host 605 is configured to: send a first command; the controller 601 is configured to: receive the first command; in response to the first command, configure a respective storage area for input data / output data in a process of executing the program by the computing processing component 603; and refresh the input data / output data in the process of executing the program into the respective storage area in batches sequentially; and a size of the input data / output data in the process of executing the program is greater than a capacity size of the respective storage area.

As shown in FIG. 12, the first memory 602 comprises a first storage area configured for input data in the process of executing the program by the computing processing component, and a second storage area 607 configured for output data in the process of executing the program by the computing processing component.

In some examples, the computational storage system further comprises a second memory coupled to the controller; the controller comprises a first memory unit and a second memory unit; a value in the first memory unit is to represent whether input data in a current respective storage area needs to be refreshed; a value in the second memory unit is to represent whether there is input data in the process of executing the program to be refreshed to the respective storage area; or the controller comprises a third memory unit and a fourth memory unit; a value in the third memory unit is to represent whether output data currently refreshed to the respective storage area needs to be stored to the second memory; and a value in the fourth memory unit is to represent whether there is output data in the process of executing the program to be stored to the second memory.

In some examples, the host is configured to: send an activation command; send a second command; the second command carries address information of a first batch of input data that needs to be refreshed to a respective storage area in the second memory; the controller is configured to: receive the activation command; in response to the activation command, activate the program; receive the second command; in response to the second command, refresh the first batch of input data into the respective storage area; based on the first batch of input data refreshed into the respective storage area being processed by the program, set a value in the first memory unit to a first value; or the host is configured to: send a third command; the third command carries address information that the first batch of output data that needs to be stored into the second memory needs to be stored in the second memory; the controller is configured to: based on a first batch of output data that needs to be stored into the second memory being refreshed into the respective storage area, set a value in the third memory unit to a fifth value; based on the value in the third memory unit being set to the fifth value, receive the third command; and in response to the third command, store the first batch of output data that needs to be stored in the second memory in the second memory.

In some examples, the host is configured to: send a command to obtain the value in the first memory unit; based on the value in the first memory unit being the first value, send a fourth command; the fourth command carries address information of a Nth batch of input data that needs to be refreshed to the respective storage area in the second memory; wherein N is an integer greater than 1; send a seventh command; the seventh command carries information that the Nth batch of input data that needs to be refreshed to a respective storage area has been refreshed to the respective storage area, and information about whether there is input data in the process of executing the program to be refreshed to the respective storage area; the controller is configured to: receive a command to obtain the value in the first memory unit; in response to the command to obtain the value in the first memory unit, send the value in the first memory unit to the host; receive the fourth command, and in response to the fourth command, refresh the Nth batch of input data into the respective storage area; receive the seventh command; in response to the information carried in the seventh command being that there is input data in the process of executing the program to be refreshed to the respective storage area, set the value in the first memory unit to a second value; or, in response to the information carried in the seventh command being that the input data in the process of executing the program has been refreshed to the respective storage area, set the value in the second memory unit to a fourth value.

In some examples, the host is configured to: send a command to obtain a value in the third memory unit; based on the value in the third memory unit being the fifth value, send a fifth command; the fifth command carries address information that the Nth batch of output data that needs to be stored into the second memory needs to be stored in the second memory; wherein N is an integer greater than 1; send an eighth command; the eighth command carries information about the Nth batch of output data has been stored into the second memory and whether there is output data in the process of executing the program to be stored in the second memory; the controller is configured to: receive a command to obtain a value in the third memory unit; in response to the command to obtain the value in the third memory unit, send the value in the third memory unit to the host; receive the fifth command; in response to the fifth command, store the Nth batch of output data into the second memory; receive the eighth command; in response to the information carried in the eighth command being that there is output data in the process of executing the program to be stored into the second memory, set a value in the third memory unit to a sixth value; or, in response to the information carried in the eighth command being that all the output data in the process of executing the program has been stored into the second memory, set a value in the fourth memory unit to an eighth value.

In some examples, the host is configured to: send a sixth command ; the sixth command carries address information of a corresponding second memory allocated to input data that needs to be refreshed to a respective storage area in the process of executing the program; or, the sixth command carries address information of a corresponding second memory allocated to output data that needs to be stored to the second memory in the process of executing the program; the controller is configured to: receive the sixth command; in response to the sixth command, refresh input data in the process of executing the program in the second memory into a respective storage area in batches sequentially, and after each time the input data in the process of executing the program in the second memory is refreshed to the respective storage area, update address information of remaining input data that needs to be refreshed to a respective storage area in the process of executing the program in the second memory; or in response to the sixth command, store output data in the process of executing the program refreshed to the respective storage area into the second memory in batches sequentially, and after each time the output data in the process of executing the program in the respective storage area is refreshed into the second memory, update address information that remaining output data that needs to be stored to the second memory in the process of executing the program needs to be stored into the second memory.

In some examples, the host is configured to: send a command to configure a plurality of storage areas for input data / output data in the process of executing the program; the controller is configured to: configure the plurality of storage areas for input data in the process of executing the program; in a process of executing the program on input data in one of the plurality of storage areas by the computing processing component, perform a refresh operation on input data in a storage area that has been processed by the program of the input data stored in the plurality of storage areas; or the controller is configured to: configure the plurality of storage areas for output data in the process of executing the program; and in a process of refreshing output data in the process of executing the program to one of the plurality of storage areas, store output data that has not been stored into a storage area of the second memory of the output data stored in the plurality of storage areas into the second memory.

Further details about the above electronic system are described in detail in the above examples of the computational storage system, and details are not described herein again for brevity.

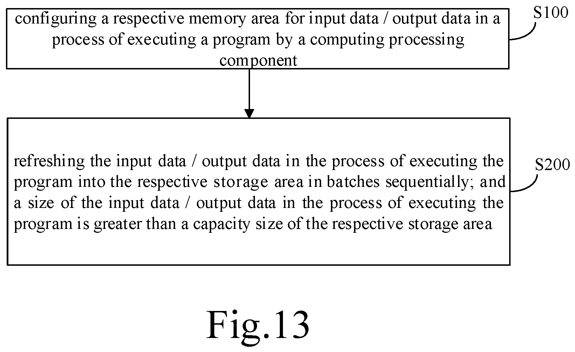

Based on the above computational storage system, an example of the present disclosure further provides an operation method for a computational storage system, as shown in FIG. 13, the operation method comprises the followings: S100, configuring a respective storage area for input data / output data in a process of executing a program by a computing processing component; S200, refreshing the input data / output data in the process of executing the program into the respective storage area in batches sequentially; and a size of the input data / output data in the process of executing the program is greater than a capacity size of the respective storage area.

In some examples, a corresponding first memory unit is configured for a respective storage area configured for input data in the process of executing the program, and a respective second memory unit is configured for the program; a value in the first memory unit is to represent whether input data in a current respective storage area needs to be refreshed; a value in the second memory unit is to represent whether there is input data in the process of executing the program to be refreshed to the respective storage area; or a corresponding third memory unit is configured for a respective storage area configured for output data in the process of executing the program, and a respective fourth memory unit is configured for the program; a value in the third memory unit is to represent whether output data currently refreshed to the respective storage area needs to be stored to the second memory; and a value in the fourth memory unit is to represent whether there is output data in the process of executing the program to be stored to the second memory.

In some examples, the operation method further comprises: receiving a first command; and in response to the first command, configuring the respective storage area for the input data / output data in the process of executing the program by the computing processing component and configuring a respective memory unit for the configured respective storage area.

In some examples, the operation method further comprises: receiving an activation command; in response to the activation command, activating the program; receiving a second command; the second command carries address information of a first batch of input data that needs to be refreshed to the respective storage area in the second memory; in response to the second command, refreshing the first batch of input data into the respective storage area; based on the first batch of input data refreshed into the respective storage area being processed by the program, setting a value in the first memory unit to a first value; or, based on a first batch of output data that needs to be stored into the second memory being refreshed into the respective storage area, setting a value in the third memory unit to a fifth value; based on the value in the third memory unit being set to the fifth value, receiving a third command; the third command carries address information that the first batch of output data that needs to be stored into the second memory needs to be stored in the second memory; and in response to the third command, storing the first batch of output data that needs to be stored in the second memory in the second memory.

In some examples, the operation method further comprises: based on the value in the first memory unit being the first value, receiving a fourth command; the fourth command carries address information of a Nth batch of input data that needs to be refreshed to the respective storage area in the second memory; in response to the fourth command, refreshing the Nth batch of input data into the respective storage area; wherein N is an integer greater than 1; based on the Nth batch of input data having been refreshed into the respective storage area, and there being input data in the process of executing the program to be refreshed to the respective storage area, setting the value in the first memory unit to a second value; or, based on the Nth batch of input data having been refreshed into the respective storage area, and all the input data in the process of executing the program having been refreshed to the respective storage area, setting the value in the second memory unit to a fourth value.

In some examples, the operation method further comprises: based on the value in the third memory unit being the fifth value, receiving a fifth command; the fifth command carries address information that the Nth batch of output data that needs to be stored into the second memory needs to be stored in the second memory; in response to the fifth command, storing the Nth batch of output data into the second memory; wherein N is an integer greater than 1; based on the Nth batch of output data having been stored into the second memory, and there being output data in the process of executing the program to be stored into the second memory, setting the value in the third memory unit to a sixth value; or, based on the Nth batch of output data having been stored into the second memory, and all the output data in the process of executing the program having been stored into the second memory, setting the value in the fourth memory unit to an eighth value.

In some examples, the operation method further comprises: when an interruption occurs in the process of executing the program, based on the value in the second memory unit being the fourth value representing that all the input data in the process of executing the program has been refreshed to the respective storage area, ending the program, and refreshing the output data into the respective storage area.

In some examples, the operation method further comprises: receiving a sixth command; the sixth command carries address information of a corresponding second memory allocated to input data that needs to be refreshed to a respective storage area in the process of executing the program, or the sixth command carries address information of a corresponding second memory allocated to output data that needs to be stored to the second memory in the process of executing the program; in response to the sixth command, refreshing input data in the process of executing the program in the second memory into a respective storage area in batches sequentially, and after each time the input data in the process of executing the program in the second memory is refreshed to the respective storage area, updating address information of remaining input data that needs to be refreshed to a respective storage area in the process of executing the program into the second memory; or in response to the sixth command, storing output data in the process of executing the program refreshed to the respective storage area into the second memory in batches sequentially, and after each time the output data in the process of executing the program in the respective storage area is refreshed into the second memory, updating address information that remaining output data that needs to be stored to the second memory in the process of executing the program needs to be stored into the second memory.

In some examples, the first memory comprises a plurality of storage areas configured for input data in the process of executing the program; in a process of executing the program on input data in one of the plurality of storage areas by the computing processing component, the operation method further comprises: performing a refresh operation on input data in a storage area that has been processed by the program of the input data stored in the plurality of storage areas; or the first memory comprises a plurality of storage areas configured for output data in the process of executing the program; and the operation method further comprises: in a process of refreshing output data in the process of executing the program to one of the plurality of storage areas, storing output data that has not been stored into a storage area of the second memory of the output data stored in the plurality of storage areas into the second memory.

The operation method of the computational storage system mentioned in the above examples is described in detail in the above examples related to the computational storage system, and details are not described herein again for brevity.

Based on the above operation method of the above computational storage system, an example of the present disclosure further provides a computer-readable storage medium, where the computer-readable storage medium stores a computer program, and the computer program, when executed by a processor, implements the operation method of the computational storage system according to any one of the above examples.

Herein, all or part of the processes in the operation method of the computational storage system in the above examples are implemented by using a computer program for instructing related hardware, and the program may be stored in a computer-readable storage medium, and when the program is executed, the program may comprise the processes of the examples of the above methods. The storage medium may be a Ferromagnetic random access memory (FRAM), a read-only memory (ROM), a programmable read-only memory (PROM), an erasable programmable read-only memory (EPROM), an electrically erasable programmable read-only memory (EEPROM), a flash memory, a magnetic surface memory, an optical disc, or a compact disc read-only memory (CD-ROM), and the like; and the storage medium may further comprise a combination of the above types of memories.

The features disclosed in the several apparatus examples provided by the present disclosure may be arbitrarily combined without conflict to obtain a new apparatus example.

The method disclosed in the several method examples provided by the present disclosure may be arbitrarily combined without conflict to obtain a new method example.

The above description is only an example of the present disclosure, but the protection scope of the present disclosure is not limited thereto, and changes or replacements that may be easily conceived by any person skilled in the art within the technical scope of the present disclosure should be covered within the protection scope of the present disclosure.

## Claims

1. A computational storage system, comprising:
a computing processing component configured to execute a program;
a first memory comprising a respective storage area configured for input data / output data in a process of executing the program by the computing processing component; and
a controller coupled to the first memory and configured to:
refresh the input data / output data in the process of executing the program into the respective storage area in batches sequentially, wherein a size of the input data / output data in the process of executing the program is greater than a capacity size of the respective storage area.

2. The computational storage system of claim 1, further comprising a second memory coupled to the controller, wherein
the controller comprises:
a first memory unit, wherein a value in the first memory unit is to represent whether input data in a current respective storage area needs to be refreshed; and
a second memory unit, wherein a value in the second memory unit is to represent whether there is input data in the process of executing the program to be refreshed to the respective storage area; or
the controller comprises:
a third memory unit, wherein a value in the third memory unit is to represent whether output data currently refreshed to the respective storage area needs to be stored to the second memory; and
a fourth memory unit, wherein a value in the fourth memory unit is to represent whether there is output data in the process of executing the program to be stored to the second memory.

3. The computational storage system of claim 2, wherein the controller is configured to:
receive a first command; and
in response to the first command, configure the respective storage area for the input data / output data in the process of executing the program by the computing processing component and configure a respective memory unit for the configured respective storage area.

4. The computational storage system of claim 3, wherein the controller is configured to:
receive an activation command;
in response to the activation command, activate the program;
receive a second command, wherein the second command carries address information of a first batch of input data that needs to be refreshed to the respective storage area in the second memory;
in response to the second command, refresh the first batch of input data into the respective storage area; and
based on the first batch of input data refreshed into the respective storage area being processed by the program, set the value in the first memory unit to a first value; or
based on a first batch of output data that needs to be stored into the second memory being refreshed into the respective storage area, set the value in the third memory unit to a fifth value;
based on the value in the third memory unit being set to the fifth value, receive a third command, wherein the third command carries address information that the first batch of output data that needs to be stored into the second memory needs to be stored in the second memory; and
in response to the third command, store the first batch of output data that needs to be stored in the second memory in the second memory.

5. The computational storage system of claim 4, wherein the controller is configured to:
based on the value in the first memory unit being the first value, receive a fourth command, wherein the fourth command carries address information of a Nth batch of input data that needs to be refreshed to the respective storage area in the second memory;
in response to the fourth command, refresh the Nth batch of input data into the respective storage area, wherein N is an integer greater than 1; and
based on the Nth batch of input data having been refreshed into the respective storage area, and there being input data in the process of executing the program to be refreshed to the respective storage area, set the value in the first memory unit to a second value; or
based on the Nth batch of input data having been refreshed into the respective storage area, and all the input data in the process of executing the program having been refreshed to the respective storage area, set the value in the second memory unit to a fourth value.

6. The computational storage system of claim 4, wherein the controller is configured to:
based on the value in the third memory unit being the fifth value, receive a fifth command, wherein the fifth command carries address information that a Nth batch of output data that needs to be stored to the second memory needs to be stored into the second memory;
in response to the fifth command, store the Nth batch of output data into the second memory, wherein N is an integer greater than 1; and
based on the Nth batch of output data having been stored into the second memory, and there being output data in the process of executing the program to be stored into the second memory, set the value in the third memory unit to a sixth value; or
based on the Nth batch of output data having been stored into the second memory, and all the output data in the process of executing the program having been stored into the second memory, set the value in the fourth memory unit to an eighth value.

7. The computational storage system of claim 2, wherein the controller is configured to:
when an interruption occurs in the process of executing the program, based on the value in the second memory unit being the fourth value representing that all the input data in the process of executing the program has been refreshed to the respective storage area, end the program, and refresh the output data into the respective storage area.

8. The computational storage system of claim 2, wherein the controller is configured to:
receive a sixth command, wherein the sixth command carries address information of a corresponding second memory allocated to input data that needs to be refreshed to a respective storage area in the process of executing the program, or the sixth command carries address information of a corresponding second memory allocated to output data that needs to be stored to the second memory in the process of executing the program; and
in response to the sixth command, refresh the input data in the process of executing the program in the second memory into a respective storage area in batches sequentially, and after each time the input data in the process of executing the program in the second memory is refreshed to the respective storage area, update address information of remaining input data that needs to be refreshed to a respective storage area in the process of executing the program in the second memory; or
in response to the sixth command, store the output data in the process of executing the program refreshed to the respective storage area into the second memory in batches sequentially, and after each time the output data in the process of executing the program in the respective storage area is refreshed into the second memory, update address information that remaining output data that needs to be stored to the second memory in the process of executing the program needs to be stored into the second memory.

9. The computational storage system of claim 8, wherein
the first memory comprises a plurality of storage areas configured for input data in the process of executing the program, in a process of executing the program on input data in one of the plurality of storage areas by the computing processing component, the controller is configured to: perform a refresh operation on input data in a storage area that has been processed by the program of the input data stored in the plurality of storage areas;
or
the first memory comprises a plurality of storage areas configured for output data in the process of executing the program, and the controller is configured to: in a process of refreshing the output data in the process of executing the program to one of the plurality of storage areas, store output data that has not been stored into a storage area of the second memory of the output data stored in the plurality of storage areas into the second memory.

10. The computational storage system of claim 1, wherein the computing processing component is configured to:
load the program to be executed; and
read input data refreshed to the respective storage area; or
refresh output data obtained after the program has processed the input data into the respective storage area.

11. The computational storage system of claim 2, comprising:
a non-volatile namespace comprising the second memory;
a computing namespace comprising the computing processing component; and
a sub-system local memory namespace comprising the first memory.

12. The computational storage system of claim 1, wherein the computational storage system supports simultaneous execution of a plurality of programs, the first memory comprises a corresponding storage area respectively configured for input data / output data in a process of executing each of the plurality of programs, and the controller is configured to:
configure a corresponding memory unit for a storage area corresponding to each of the plurality of programs respectively, and configure a corresponding memory unit for each of the plurality of programs.

13. An electronic system, comprising:
a host configured to:
send a first command; and
a computational storage system coupled to the host and comprising:
a computing processing component configured to execute a program;
a first memory; and
a controller coupled to the first memory and configured to:
receive the first command;
in response to the first command, configure a respective storage area for input data / output data in a process of executing the program by the computing processing component; and
refresh the input data / output data in the process of executing the program into the respective storage area in batches sequentially, wherein a size of the input data / output data in the process of executing the program is greater than a capacity size of the respective storage area.

14. The electronic system of claim 13, wherein the computational storage system further comprises a second memory coupled to the controller, wherein
the controller comprises:
a first memory unit, wherein a value in the first memory unit is to represent whether input data in a current respective storage area needs to be refreshed; and
a second memory unit, wherein a value in the second memory unit is to represent whether there is input data in the process of executing the program to be refreshed to the respective storage area; or
the controller comprises:
a third memory unit, wherein a value in the third memory unit is to represent whether output data currently refreshed to the respective storage area needs to be stored to the second memory; and
a fourth memory unit, wherein a value in the fourth memory unit is to represent whether there is output data in the process of executing the program to be stored to the second memory.

15. The electronic system of claim 14, wherein
the host is configured to:
send an activation command; and
send a second command, wherein the second command carries address information of a first batch of input data that needs to be refreshed to the respective storage area in the second memory; and
the controller is configured to:
receive the activation command;
in response to the activation command, activate the program;
receive the second command;
in response to the second command, refresh the first batch of input data into the respective storage area; and
based on the first batch of input data refreshed into the respective storage area being processed by the program, set the value in the first memory unit to a first value; or
the host is configured to:
send a third command, wherein the third command carries address information that a first batch of output data that needs to be stored into the second memory needs to be stored in the second memory; and
the controller is configured to:
based on the first batch of output data that needs to be stored into the second memory being refreshed into the respective storage area, set the value in the third memory unit to a fifth value;
based on the value in the third memory unit being set to the fifth value, receive the third command; and
in response to the third command, store the first batch of output data that needs to be stored in the second memory in the second memory.

16. The electronic system of claim 15, wherein
the host is configured to:
send a command to obtain the value in the first memory unit;
based on the value in the first memory unit being the first value, send a fourth command, wherein the fourth command carries address information of a Nth batch of input data that needs to be refreshed to the respective storage area in the second memory, N is an integer greater than 1; and
send a seventh command, wherein the seventh command carries information that the Nth batch of input data that needs to be refreshed to the respective storage area has been refreshed to the respective storage area, and information about whether there is input data in the process of executing the program to be refreshed to the respective storage area; and
the controller is configured to:
receive the command to obtain the value in the first memory unit;
in response to the command to obtain the value in the first memory unit, send the value in the first memory unit to the host;
receive the fourth command, and in response to the fourth command, refresh the Nth batch of input data into the respective storage area;
receive the seventh command; and
in response to the information carried in the seventh command being that there is input data in the process of executing the program to be refreshed to the respective storage area, set the value in the first memory unit to a second value; or
in response to the information carried in the seventh command being that all the input data in the process of executing the program has been refreshed to the respective storage area, set the value in the second memory unit to a fourth value.

17. The electronic system of claim 15, wherein
the host is configured to:
send a command to obtain the value in the third memory unit;
based on the value in the third memory unit being the fifth value, send a fifth command, wherein the fifth command carries address information that a Nth batch of output data that needs to be stored into the second memory needs to be stored in the second memory, N is an integer greater than 1; and
send an eighth command, wherein the eighth command carries information about the Nth batch of output data has been stored into the second memory and whether there is output data in the process of executing the program to be stored in the second memory; and
the controller is configured to:
receive the command to obtain the value in the third memory unit;
in response to the command to obtain the value in the third memory unit, send the value in the third memory unit to the host;
receive the fifth command;
in response to the fifth command, store the Nth batch of output data into the second memory;
receive the eighth command; and
in response to the information carried in the eighth command being that there is output data in the process of executing the program to be stored into the second memory, set the value in the third memory unit to a sixth value; or
in response to the information carried in the eighth command being that all the output data in the process of executing the program has been stored into the second memory, set the value in the fourth memory unit to an eighth value.

18. The electronic system of claim 14, wherein
the host is configured to:
send a sixth command, wherein the sixth command carries address information of a corresponding second memory allocated to input data that needs to be refreshed to a respective storage area in the process of executing the program, or the sixth command carries address information of a corresponding second memory allocated to output data that needs to be stored to the second memory in the process of executing the program; and
the controller is configured to:
receive the sixth command; and
in response to the sixth command, refresh the input data in the process of executing the program in the second memory into a respective storage area in batches sequentially, and after each time the input data in the process of executing the program in the second memory is refreshed to the respective storage area, update address information of remaining input data that needs to be refreshed to a respective storage area in the process of executing the program in the second memory; or
in response to the sixth command, store the output data in the process of executing the program refreshed to the respective storage area into the second memory in batches sequentially, and after each time the output data in the process of executing the program in the respective storage area is refreshed into the second memory, update address information that remaining output data that needs to be stored to the second memory in the process of executing the program needs to be stored into the second memory.

19. The electronic system of claim 18, wherein
the host is configured to:
send a command to configure a plurality of storage areas for input data / output data in the process of executing the program; and
the controller is configured to:
configure the plurality of storage areas for input data in the process of executing the program, and in a process of executing the program on input data in one of the plurality of storage areas by the computing processing component, perform a refresh operation on input data in a storage area that has been processed by the program of the input data stored in the plurality of storage areas;
or
the controller is configured to:
configure the plurality of storage areas for output data in the process of executing the program, and in a process of refreshing the output data in the process of executing the program to one of the plurality of storage areas, store output data that has not been stored into a storage area of the second memory of the output data stored in the plurality of storage areas into the second memory.

20. An operation method for a computational storage system, comprising:
configuring a respective storage area for input data / output data in a process of executing a program by a computing processing component; and
refreshing the input data / output data in the process of executing the program into the respective storage area in batches sequentially, wherein a size of the input data / output data in the process of executing the program is greater than a capacity size of the respective storage area.

21. The operation method of claim 20, wherein
a corresponding first memory unit is configured for a respective storage area configured for input data in the process of executing the program, and a respective second memory unit is configured for the program, wherein a value in the first memory unit is to represent whether input data in a current respective storage area needs to be refreshed, and a value in the second memory unit is to represent whether there is input data in the process of executing the program to be refreshed to the respective storage area;
or
a corresponding third memory unit is configured for a respective storage area configured for output data in the process of executing the program, and a respective fourth memory unit is configured for the program, wherein a value in the third memory unit is to represent whether output data currently refreshed to the respective storage area needs to be stored to the second memory, and a value in the fourth memory unit is to represent whether there is output data in the process of executing the program to be stored to the second memory.

22. The operation method of claim 21, further comprising:
receiving a first command; and
in response to the first command, configuring the respective storage area for the input data / output data in the process of executing the program by the computing processing component and configuring a respective memory unit for the configured respective storage area.

23. The operation method of claim 22, further comprising:
receiving an activation command;
in response to the activation command, activating the program;
receiving a second command, wherein the second command carries address information of a first batch of input data that needs to be refreshed to the respective storage area in the second memory;
in response to the second command, refreshing the first batch of input data into the respective storage area; and
based on the first batch of input data refreshed into the respective storage area being processed by the program, setting the value in the first memory unit to a first value;
or
based on a first batch of output data that needs to be stored into the second memory being refreshed into the respective storage area, setting the value in the third memory unit to a fifth value;
based on the value in the third memory unit being set to the fifth value, receiving a third command, wherein the third command carries address information that the first batch of output data that needs to be stored into the second memory needs to be stored in the second memory; and
in response to the third command, storing the first batch of output data that needs to be stored in the second memory into the second memory.

24. The operation method of claim 23, further comprising:
based on the value in the first memory unit being the first value, receiving a fourth command, wherein the fourth command carries address information of a Nth batch of input data that needs to be refreshed to the respective storage area in the second memory;
in response to the fourth command, refreshing the Nth batch of input data into the respective storage area, wherein N is an integer greater than 1; and
based on the Nth batch of input data having been refreshed into the respective storage area, and there being input data in the process of executing the program to be refreshed to the respective storage area, setting the value in the first memory unit to a second value; or
based on the Nth batch of input data having been refreshed into the respective storage area, and all the input data in the process of executing the program having been refreshed to the respective storage area, setting the value in the second memory unit to a fourth value.

25. The operation method of claim 23, further comprising:
based on the value in the third memory unit being the fifth value, receiving a fifth command, wherein the fifth command carries address information that a Nth batch of output data that needs to be stored to the second memory needs to be stored into the second memory;
in response to the fifth command, storing the Nth batch of output data into the second memory, wherein N is an integer greater than 1; and
based on the Nth batch of output data having been stored into the second memory, and there being output data in the process of executing the program to be stored into the second memory, setting the value in the third memory unit to a sixth value; or
based on the Nth batch of output data having been stored into the second memory, and all the output data in the process of executing the program having been stored into the second memory, setting the value in the fourth memory unit to an eighth value.

26. The operation method of claim 21, further comprising:
when an interruption occurs in the process of executing the program, based on the value in the second memory unit being the fourth value representing that all the input data in the process of executing the program has been refreshed to the respective storage area, ending the program, and refreshing the output data into the respective storage area.

27. The operation method of claim 21, further comprising:
receiving a sixth command, wherein the sixth command carries address information of a corresponding second memory allocated to input data that needs to be refreshed to a respective storage area in the process of executing the program, or the sixth command carries address information of a corresponding second memory allocated to output data that needs to be stored to the second memory in the process of executing the program; and
in response to the sixth command, refreshing the input data in the process of executing the program in the second memory into a respective storage area in batches sequentially, and after each time the input data in the process of executing the program in the second memory is refreshed to the respective storage area, updating address information of remaining input data that needs to be refreshed to a respective storage area in the process of executing the program in the second memory; or
in response to the sixth command, storing output data in the process of executing the program refreshed to the respective storage area into the second memory in batches sequentially, and after each time the output data in the process of executing the program in the respective storage area is refreshed into the second memory, updating address information that remaining output data that needs to be stored to the second memory in the process of executing the program needs to be stored into the second memory.

28. The operation method of claim 27, wherein
the first memory comprises a plurality of storage areas configured for input data in the process of executing the program, in a process of executing the program on input data in one of the plurality of storage areas by the computing processing component, the operation method further comprises: performing a refresh operation on input data in a storage area that has been processed by the program of the input data stored in the plurality of storage areas;
or
the first memory comprises a plurality of storage areas configured for output data in the process of executing the program; and the operation method further comprises: in a process of refreshing the output data in the process of executing the program to one of the plurality of storage areas, storing output data that has not been stored into a storage area of the second memory of the output data stored in the plurality of storage areas into the second memory.
